# NEUE EUROPÄISCHE PATENTSCHRIFT

(11) **EP 1 888 338 B2**
(45) Veröffentlichungstag und Bekanntmachung des Hinweises auf die Entscheidung über den Einspruch: **29.11.2017**
(45) Hinweis auf die Patenterteilung: 29.10.2008
(21) Anmeldenummer: 06754883.4
(22) Anmeldetag: 27.04.2006
(51) Int. Cl.: B41F 17/00, G06K 17/00, B41F 33/00, H05K 3/12

(54) **DRUCKMASCHINE UND EIN VERFAHREN ZUR HERSTELLUNG EINES DRUCKERZEUGNISSES**
PRINTING MACHINE AND A METHOD FOR PRODUCING A PRINTED PRODUCT
MACHINE A IMPRIMER ET PROCEDE POUR PRODUIRE UN PRODUIT IMPRIME

(30) Priorität: 07.06.2005 DE 102005026127
(43) Veröffentlichungstag der Anmeldung: 20.02.2008
(73) Patentinhaber: Koenig & Bauer AG, 97080 Würzburg (DE)
(72) Erfinder: STIEL, Jürgen, Alfred, 97289 Thüngen (DE)
(74) Vertreter: Koenig & Bauer AG
(86) Internationale Anmeldenummer: PCT/EP2006/061872
(87) Internationale Veröffentlichungsnummer: WO 2006/131422

(56) Entgegenhaltungen:
- WO-A-02/35463
- WO-A-2005/013179
- WO-A-2005/021276
- US-A1- 2003 061 947

## Beschreibung

Die Erfindung betrifft eine Druckmaschine und ein Verfahren zur Herstellung eines Druckerzeugnisses gemäß dem Oberbegriff des Anspruchs 1 oder 34.

Insbesondere betrifft die Erfindung diejenige Technologie, bei der ein berührungsloses Identifikationsmerkmal wie insbesondere ein RFID-System (RFID = Radio Frequency Identification) bzw. ein Teil hiervon zum Zwecke der elektronischen Etikettierung von Objekten wie beispielsweise Verpackungen auf einen Bedruckstoff wie beispielsweise ein Etikett oder direkt auf eine Verpackung aufgebracht wird (elektronische Etikettierung mittels so genannter Smart Labels). Das zentrale Element eines RFID-Systems ist ein Transponder, der mittels Funkwellen beispielsweise im Langwellenbereich Daten mit einer Sende-/Empfangsstation austauscht. Die wesentlichen Komponenten eines Transponders sind insbesondere ein integrierter Schaltkreis zur Steuerung der Transponderfunktionen und ein Antennenschwingkreis für den Empfang und das Senden von Funkwellen. Passive Transponder weisen keine eigene Energieversorgung auf, sondern beziehen ihre Energie aus dem Sendesignal der Sende-/Empfangsstation.

Ein RFID-System ermöglicht somit mittels der Transponder-Technologie eine berührungslose, drahtlose Identifikation von Produkten wie beispielsweise Verpackungen, wobei anstelle von oder zusätzlich zu Identifizierungsdaten auch andere, komplexere Daten wie beispielsweise Verkaufspreise, Herstellungsdaten, Verfallsdaten, Herstellungsort, Verschlüsselungsdaten u. dgl. übertragen werden können.

Aus der WO 2005/013189 A2 ist ein Verfahren zur Herstellung von RFID- Etiketten unter Verwendung eines Druckverfahrens bekannt, bei dem die Antenne und ein Schwingkreis des Transponders durch Bogenoffsetdruck oder mit einer Hockdruckplatte auf den Bedruckstoff appliziert wird.

Aus der WO 2005/021276 A1 ist ein Verfahren zum Bedrucken eines Bedruckstoffs bekannt, wobei der Bedruckstoff durch zwei inline geschaltete Druckwerke einer Druckmaschine geführt wird und der Bedruckstoff in einem Druckwerk mit Farbe bedruckt wird und in einem anderen Druckwerk der Bedruckstoff mit elektrischen Leiterbahnen in Form einer Antenne eines RFID-Systems bedruckt wird. Außerdem kann zusätzlich ein Chip auf den Bedruckstoff elektrisch kontaktierend mit der Antenne aufgeklebt werden.

Aus der WO 96/40443 A1 ist eine Druckmaschine zum Drucken von elektrischen Schaltkreisen direkt auf ein Substrat unter Verwendung einer elektrisch leitfähigen Flüssigkeit bekannt, wobei innerhalb der Maschine zusätzliche Stationen zum Prüfen der Qualität der bereits gedruckten Schaltkreise vorgesehen sein können.

Aus der WO 2005/028203 A1 ist ein RFID Etikett mit einer RFID Antenne und einem RFID Chip bekannt.

Die DE 103 32 212 A1 zeigt eine Vorrichtung zur Qualitätskontrolle von Bogen mittels mehrerer Inspektionseinrichtungen.

Die DE 103 03 282 A1 beschreibt ein Inline-Qualitätskontrollsystem für bedruckte, geprägte und/oder strukturierte Materialbahnen, das es ermöglicht, unterschiedliche Eigenschaften der Materialbahn zu erfassen.

Die DE 600 09 643 T2 offenbart die Verwendung verschiedener Druckverfahren zur Herstellung eines Resonanzetiketts.

Die US 2003/0061947 A1 offenbart eine Vorrichtung zum Drucken und Applizieren von RFID Etiketten, wobei eine Prüfung des RFID Etiketts vor dem Applizieren erfolgt.

Der Erfindung liegt die Aufgabe zugrunde, eine Druckmaschine und ein Verfahren zur Herstellung eines Druckerzeugnisses zu schaffen.

Die Aufgabe wird erfindungsgemäß durch die Merkmale des Anspruchs 1 oder 34 gelöst.

Die mit der Erfindung erzielbaren Vorteile bestehen insbesondere darin, dass aufgrund der in die Druckmaschine vorzugsweise inline integrierten Prüfeinrichtungen, die zusätzlich zur Prüfung der Identifikationsmerkmale vorzugsweise auch zur Überprüfung des Druckbildes ausgelegt sein können, auf vergleichsweise einfache Weise Identifikationsmerkmale wie insbesondere RFID-Systeme tragende Druckerzeugnisse von insgesamt hoher Qualität bzw. mit niedriger Fehlerquote erzeugt werden können.

Ausführungsbeispiele der Erfindung sind in den Zeichnungen dargestellt und werden im Folgenden näher beschrieben.

Es zeigen:
- Fig. 1: ein erstes Ausführungsbeispiel einer Druckmaschine in Seitenansicht in halbschematischer Darstellung;
- Fig. 2: ein zweites Ausführungsbeispiel einer Druckmaschine in Seitenansicht in schematischer Darstellung;
- Fig. 3: die Anordnung eines Inline-Inspektionssystems in einer Druckmaschine nach Fig. 1 oder 2;
- Fig. 4: eine perspektivische Darstellung des Inline-Inspektionssystems nach Fig. 3 in der Druckmaschine;
- Fig. 5: eine weitere perspektivische Darstellung des Inline-Inspektionssystems nach Fig. 3 in der Druckmaschine;
- Fig. 6: eine Draufsicht auf einen in einer Druckmaschine nach Fig. 1 oder 2 bewegten Bedruckstoff mit einem Beleuchtungsstreifen;
- Fig. 7: eine Seitenansicht eines weiteren Inline-Inspektionssystems einer Druckmaschine nach Fig. 1 oder 2.
- Fig. 8: eine einzelne Lichtquelle der Beleuchtungseinrichtung des Inline-Inspektionssystems nach Fig. 7;
- Fig. 9: eine Seitenansicht des Inline-Inspektionssystems.

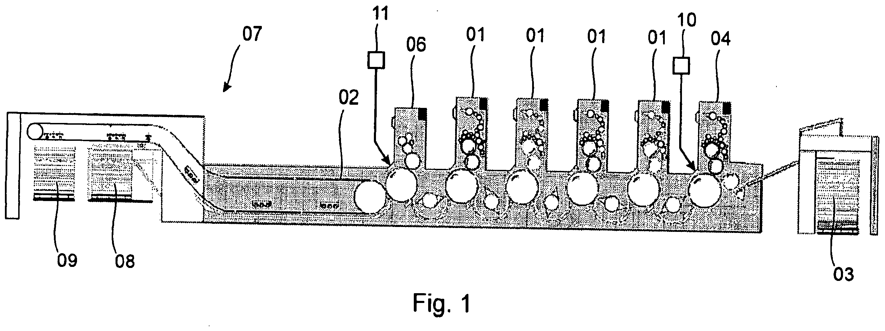

Es wird zunächst auf Fig. 1 Bezug genommen. Im Falle des dort gezeigten Ausführungsbeispiels ist die Druckmaschine eine Offsetrotationsdruckmaschine. Es versteht sich jedoch, dass eine Druckmaschine auch nach einem anderen Druckverfahren arbeiten könnte. Weiterhin zeigt die Fig. 1 zur Vereinfachung der Darstellung eine Bogenoffsetdruckmaschine allein für den Schöndruck.

Die Offsetrotationsdruckmaschine gemäß dem gezeigten Ausführungsbeispiel arbeitet im Vierfarbendruck. Es versteht sich, dass ebenso Ausführungsformen möglich sind, bei denen die Druckmaschine zum Verdrucken von mehr oder weniger Farben ausgebildet ist.

Die Bogenoffsetdruckmaschine gemäß Fig. 1 ist zum einseitigen Bedrucken von Bedruckstoffen 02, z. B. von Bogen 02 ausgebildet, die von einem Vorratsstapel 03 abgenommen werden und nacheinander vier Druckwerke 01 beispielsweise für die Farben Cyan, Magenta, Yellow und Black durchlaufen. In Transportrichtung der Bogen 02 gesehen vor den Druckwerken 01 ist inline zu diesen Druckwerken 01 eine Applikationseinrichtung 04 angeordnet, über die auf die Bogen 02 ein berührungsloses Identifikationsmerkmal, beispielsweise ein RFID-System bzw. ein Teil eines RFID-Systems wie beispielsweise eine Antenne eines Transponders appliziert wird. Das RFID-System weist vorzugsweise eine Resonanfrequenz von 8,2 MHz oder 13,56 MHz auf. Im Falle des Ausführungsbeispiels ist die Applikationseinrichtung 04, z. B. Druckeinrichtung 04, ein weiteres, nach dem Offsetverfahren arbeitendes Druckwerk 04, über welches ein elektrisch leitfähiges Material, insbesondere Druckfarbe, welches farbig oder transparent sein kann, in Form von elektrischen Leiterbahnen, die eine Antenne eines Transponders bilden können, verdruckt wird. In alternativer Ausgestaltung kann das Druckwerk 04 nach einem anderen Druckverfahren arbeiten, insbesondere nach einem Tiefdruckverfahren oder einem Hochdruckverfahren.

Es werden somit im Falle der beschriebenen Druckmaschine zunächst die Identifikationsmerkmale (bzw. Teile hiervon) aufgebracht und dann der Bogen 02 im Mehrfarbendruck bedruckt, wobei die Identifikationsmerkmale farblos sein können und der Mehrfarbendruck die Identifikationsmerkmale überdrucken kann oder auch nicht. Zwischen der Applikationseinrichtung 04 und dem anschließenden Druckwerk 01 kann bei Bedarf eine Zwischentrocknung (nicht dargestellt) vorgesehen sein. Grundsätzlich könnte die Applikationseinrichtung 04 in Transportrichtung der Bogen 02 gesehen auch hinter den Druckwerken 01 angeordnet sein.

Die Applikationseinrichtung 04 kann gemäß einem weiteren, nicht dargestellten Ausführungsbeispiel auch aus z. B. drei hintereinander geschalteten Druckwerken bestehen, wobei in einem ersten Druckwerk ein elektrisch halbleitfähiges, vorzugsweise organisches Material wie beispielsweise elektrisch halbleitfähige Polythropen oder Polymere oder elektrisch leitende Materialien (wie z. B. Kupfer, Aluminium oder Silber) verdruckt wird, in einem zweiten Druckwerk ein elektrisch isolierendes Material, vorzugsweise ein Polyoletin (beispielsweise Polyethylen, Polypropylen, lonomer, Polystyrol, Polyester, ein Ethylen-Methacryl-Säure-Copolymer) oder Polymeren und in einem dritten Druckwerk ein elektrisch leitfähiges Material. Auf diese Weise können auf den Bedruckstoff aktive Bauelemente z. B. in Form von Transistoren aufgedruckt werden, die zu Halbleiterchips verschaltet sein können.

Vorzugsweise wird in einem Druckwerk 04 elektrisch halbleitendes Polymer und in einem anderen z.B. nachfolgendem Druckwerk 04 ein elektrisch isolierendes Polymer aufgebracht. Wahlweise kann zusätzlich in einer weiteren oder mehreren weiteren Druckwerken 04 ein elektrisch leitfähiges Polymer, vorzugsweise für die Elektrodenstruktur aufgedruckt werden.

Diese Polymere sind vorzugsweise in für Druck bestimmten Lösungsmittel löslich und somit z. B. als druckbare Tinte verwendbar.

In Transportrichtung der Bogen 02 gesehen nach den Druckwerken 01 ist inline zu den Druckwerken 01 eine Finishing-Station 06 angeordnet, die beispielsweise ein Lackwerk 06 sein bzw. umfassen kann. Anschließend an die Finishing-Station 06 werden die bedruckten und mit dem berührungslosen Identifikationsmerkmal bzw. mehreren solcher Identifikationsmerkmalen versehenen Bogen 02 über eine Auslageverlängerung 07 auf wahlweise einem von zwei hintereinander geschalteten Ablagestapeln 08; 09 abgelegt, wobei beispielsweise der Ablagestapel 08 zur Aufnahme von Makulatur und der Ablagestapel 09 zur Aufnahme von ordnungsgemäßen Druckerzeugnissen bestimmt ist, so dass die fehlerhaften Bogen 02 aussortiert werden können

Die Druckerzeugnisse können insbesondere Faltkartons oder Etiketten sein. Die Bogen 02 bzw. Zylinder der Druckwerke 01 bzw. der Applikationseinrichtung 04 und der Finishing-Station 06 sind vorzugsweise so dimensioniert, dass sowohl in axialer Richtung der Zylinder bzw. in Richtung der Breite der Bogen 02 als auch in Umfangsrichtung der Zylinder bzw. in Längsrichtung der Bogen 02 jeweils mehrere Nutzen vorgesehen sind. Dementsprechend wird auf jeden Bogen 02 eine Vielzahl von Identifikationsmerkmalen aufgebracht.

Die Druckmaschine umfasst vorzugsweise berührungslos arbeitende Prüfeinrichtungen 10; 11 zur Prüfung der Qualität der Druckerzeugnisse bzw. der Funktion der hierauf aufgebrachten Identifikationsmerkmale, wobei die Funktionsprüfung auch eine etwa erforderliche vorherige Konfiguration umfassen kann, wie weiter unten im Einzelnen beschrieben erläutert wird. Die Prüfeinrichtungen 10; 11 können insbesondere die optischen Eigenschaften wie z. B. Farbe und Rasterhaltigkeit des Druckbildes oder Form der aufgebrachten Identifikationsmerkmale und/oder die elektrischen bzw. elektromagnetischen Eigenschaften der Identifikationsmerkmale wie Leitfähigkeit der aufgebrachten Leiterbahnen und/oder Frequenz des aufgebrachten Schwingkreises prüfen, beispielsweise auf induktivem Wege.

Im Falle des Ausführungsbeispiels gemäß Fig. 1 kann die Prüfeinrichtung 10, die im Anschluss an die Applikationseinrichtung 04 angeordnet ist, eine optische Prüfeinrichtung 10 sein, die die aufgebrachten Identifikationsmerkmale hinsichtlich ihrer optischen Merkmale überprüft. Auch kann die Prüfeinrichtung 10 eine elektrische bzw. elektromagnetische Prüfeinrichtung 10 sein, welche die aufgebrachten Identifikationsmerkmale hinsichtlich ihrer elektrischen und/oder magnetischen und/oder elektromagnetischen Eigenschaften überprüft. Des Weiteren kann die Prüfeinrichtung 10 zur Überprüfung sowohl der optischen als auch der elektrischen bzw. magnetischen bzw. elektromagnetischen Eigenschaften der Identifikationsmerkmale ausgebildet sein bzw. es können zwei Prüfeinrichtungen 10 hintereinander vorgesehen sein, eine zur optischen Prüfung und eine zur elektrischen bzw. magnetischen bzw. elektromagnetischen Prüfung.

Grundsätzlich könnte die Prüfeinrichtung 10 auch an anderer Stelle innerhalb der Druckmaschine angeordnet sein, beispielsweise im Anschluss an das in Förderrichtung der Bogen 02 gesehen letzte Druckwerk 01 oder im Anschluss an die Finishing-Station 06. Falls anschließend an die Applikationseinrichtung 04 eine Zwischentrocknung erfolgt, kann die Prüfeinrichtung 10 auch im Anschluss an die Zwischentrocknung angeordnet werden.

Die im Anschluss an die Finishing-Station 06 angeordnete Prüfeinrichtung 11, die auch im Anschluss an das letzte Druckwerk 01 angeordnet sein könnte, umfasst vorzugsweise eine optische Prüfung des mittels der Druckwerke 01 aufgebrachten Druckbildes. Diese optische Prüfung kann insbesondere eine Kontrolle der Farbgebung, und/oder der Farbdichte und/oder des Registers umfassen. Die Prüfeinrichtung 11 kann weiterhin eine optische Prüfung der Identifikationsmerkmale mit umfassen, insbesondere dann, wenn eine solche optische Prüfung in der Prüfeinrichtung 10 nicht erfolgt ist. Auch kann die Prüfeinrichtung 11 ggf. eine elektrische bzw. magnetische bzw. elektromagnetische Prüfung der Identifikationsmerkmale mit umfassen, insbesondere dann, wenn eine solche Prüfung in der Prüfeinrichtung 10 nicht erfolgte oder die Prüfeinrichtung 10 an dieser Stelle nicht vorgesehen ist. Dementsprechend können ggf. auch zwei oder mehr Prüfeinrichtungen 11 hintereinander geschaltet sein.

Auch ist es möglich, unterschiedliche Eigenschaften der Identifikationsmerkmale an unterschiedlichen Stellen bzw. in unterschiedlichen Prüfeinrichtungen 10; 11 zu kontrollieren, beispielsweise die Resonanzfrequenzen der Schwingkreise in der Prüfeinrichtung 10 und die elektrischen Eigenschaften der Leiterbahnen in Prüfeinrichtung 11.

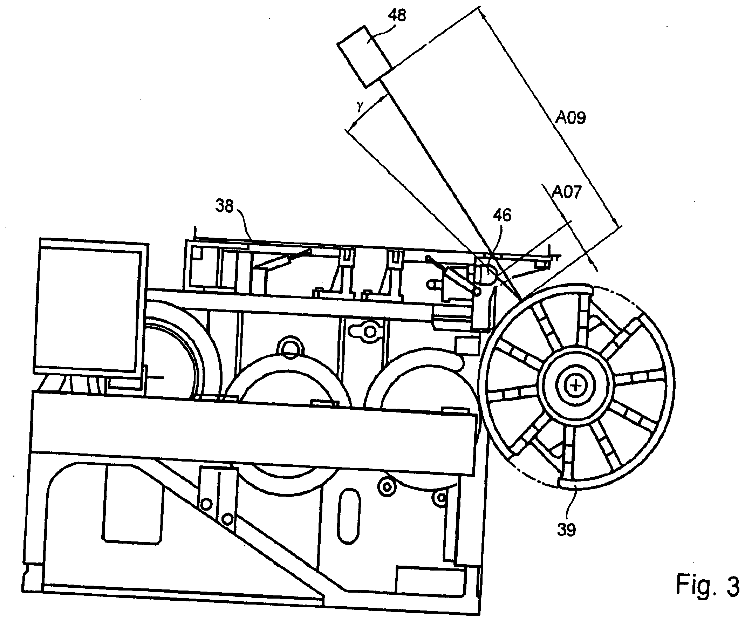

Die Prüfeinrichtung 11 kann ggf. auch im Anschluss an das in Förderrichtung der Bogen 02 gesehen letzte Druckwerk 01 bzw. zwischen diesem Druckwerk 01 und der Finishing-Station 06 angeordnet sein. Die Prüfeinrichtung 11 kann beispielsweise, wie weiter unten näher erläutert, eine CCD-Flächenkamera oder eine Kamera mit CMOS-Chip oder eine CCD-Zeilenkamera umfassen, die in Transportrichtung gesehen am letzten Druckwerk 01, insbesondere an dessen Gegendruckzylinder 39 (vgl. Fig. 3), oder am Lackwerk 06 angeordnet ist.

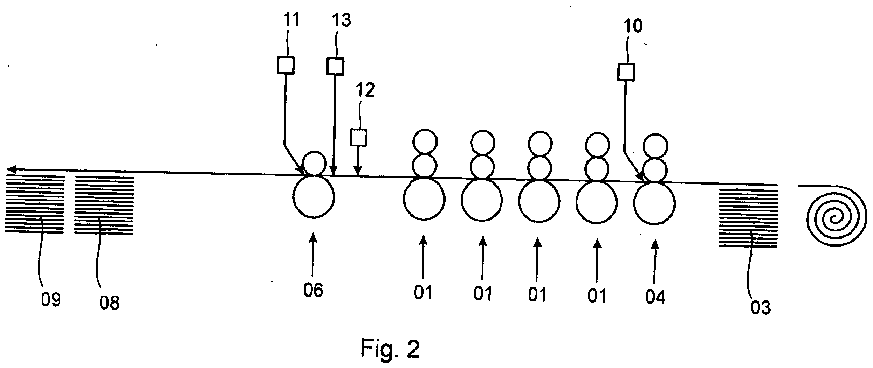

Es wird nun auf das Ausführungsbeispiel gemäß Fig. 2 Bezug genommen, dessen Aufbau in großen Teilen demjenigen gemäß Fig. 1 entspricht, so dass insoweit auf die obige Beschreibung verwiesen wird. Im Falle dieses Ausführungsbeispiels ist zusätzlich inline eine Applikationseinrichtung 12, z. B. eine Aufklebeinrichtung 12 vorgesehen, über die Teile von Identifikationsmerkmalen, insbesondere Chips von RFID-Systemen, auf die Bogen 02 aufgebracht, insbesondere aufgeklebt, werden. Wie dargestellt ist die Aufklebeinrichtung 12 zwischen dem letzten Druckwerk 01 und der Finishing-Station 06 angeordnet, sie könnte jedoch auch unmittelbar im Anschluss an das letzte Druckwerk 01 (z. B. mit dessen Gegendruckzylinder zusammenarbeitend) oder unmittelbar im Anschluss an die Finishing-Station 06 (z. B. mit einem Zylinder hiervon zusammenarbeitend) oder hinter der Finishing-Station 06 angeordnet sein.

Zur Überprüfung der elektrischen/elektronischen Funktionen dieser Chips kann eine weitere Prüfeinrichtung 13 im Anschluss an die Aufklebeinrichtung 12 vorgesehen sein, welche auch eine physische Kontaktierung der Chips mittels Messspitzen umfassen kann. Diese Prüfeinrichtung 13 kann auch so ausgebildet sein, dass sie ebenfalls die in der Applikationseinrichtung 04 aufgebrachten Teile der Identifikationsmerkmale zum Zwecke der Überprüfung kontaktiert, beispielsweise, um die Leitfähigkeit der aufgebrachten Leiterbahnen zu kontrollieren. Eine solche kontaktierende Prüfeinrichtung 13 kann alternativ oder zusätzlich auch im Anschluss an die Applikationseinrichtung 04 angeordnet werden (auch im Falle des Ausführungsbeispiels nach Fig.1).

Im Folgenden wird eine Möglichkeit einer Überprüfung der elektrischen bzw. elektronischen bzw. elektromagnetischen Eigenschaften eines auf die Bogen 02 aufgebrachten RFID-Systems mittels der Prüfeinrichtungen 10 bzw. 11 bzw. 13 beispielsweise erläutert. Es wird davon ausgegangen, dass jeweils ein vollständiger Transponder aufgebracht wurde, also ein Antennenschwingkreis zum Senden bzw. Empfang von Funkwellen und ein IC zur Steuerung der Funkwellen. Falls beispielsweise nur der jeweilige Antennenschwingkreis aufgebracht wird, versteht es sich, dass die entsprechende IC-Prüfung entfällt. Auch kann es ausreichend sein, nur eine der mehreren möglichen prüfbaren Funktionen zu überprüfen.

Die Prüfung erfolgt im laufenden Produktionsprozess und es wird jeder Transponder einzeln geprüft. Grundsätzlich erfolgt die Prüfung eines jeden Transponders in zwei aufeinanderfolgenden Schritten, nämlich einem ersten Schritt, in dem eine Konfiguration eines Transponders erfolgt und einem zweiten Schritt, in dem die Funktionen des konfigurierten Transponders getestet werden.

Zur Konfiguration des Transponders kann der IC des Transponders an hierfür vorgesehenen Messkontakten mit Messspitzen elektrisch kontaktiert werden, die (mittelbar) mit einer Konfigurations-Datenverarbeitungsanlage in Verbindung stehen. Es wird zunächst durch Vergleich mit einer Referenzspannung überprüft, ob ein ordnungsgemäßer elektrischer Kontakt besteht; andernfalls wird der entsprechende Bogen 02 der Makulatur zugeordnet. Sodann wird die Frequenz des mit dem IC verbundenen Antennenschwingkreises über eine Pulsweitemessung bestimmt, indem die Anzahl der Schwingungen eines Referenzsignals während der Messdauer bestimmt wird und hieraus die Frequenz des Messsignals errechnet wird. Außerdem werden die Identifikationsdaten wie insbesondere die Identifikationsnummer und ggf., für eine digitale Signatur, ein Schlüssel aufprogrammiert, der nur dem authentisierten Transponder und dem Reader (Sende-/Empfangsstation) bekannt ist.

Im anschließenden Funktionstest erfolgt eine Überprüfung der (vorher eingestellten) Betriebsparameter und es werden berührungslos die Funktionen des Transponders getestet. Hierzu werden die Transponder zwischen einer Sendespule, die ein kontinuierliches Sinussignal erzeugt, und einer Empfängerspule angeordnet. Zunächst wird über die Sendespule mittels eines unmodulierten Sinussignals der Energiespeicher des Transponders aufgeladen. Sodann werden über ein moduliertes Sinussignal die erforderlichen Befehle und Daten zum Transponder gesendet. Anschließend wird das Sendesignal abgeschaltet und der Transponder sendet nunmehr ein frequenzmoduliertes Antwortsignal, welches ausgewertet werden kann, um die korrekte Funktion des Transponders zu überprüfen und dessen Parameter wie z. B. Sendefrequenz oder Sendefeldstärke zu berechnen.

Die Güte des Transponder-Antennenschwingkreises kann dadurch ermittelt werden, dass der Antennenschwingkreis zur Eigenschwingung angeregt wird und entsprechende Rückschlüsse aus dem exponentiellen Abklingen des an der Empfängerspule empfangenen Signals gezogen werden.

Im Folgenden wird eine Möglichkeit einer Überprüfung der optischen Eigenschaften des mittels der Druckwerke 01 erzeugten Druckbildes und/oder eines auf die Bogen 02 aufgebrachten RFID-Systems mittels der Prüfeinrichtungen 10 bzw. 11 beispielsweise erläutert. Die im Folgenden beschriebene optische Prüfungs- bzw. Inspektionseinrichtung bezieht sich insbesondere auf in einer Rotationsdruckmaschine im Offsetdruck hergestellte Druckerzeugnisse, ist jedoch zumindest sinngemäß auch bei anderen Druckmaschinen anwendbar, beispielsweise bei einer im Stahlstichverfahren, im Siebdruckverfahren oder im Heißprägeverfahren druckende Druckmaschine.

Soweit im Folgenden von "Bild" o. dgl. die Rede ist, ist hierunter auch die der optischen Inspektion zugängliche visuelle Erscheinung eines Identifikationsmerkmals zu subsumieren.

Ein verwendbares Inline-Inspektionssystem (Prüfeinrichtung 10; 11) zur Beurteilung einer Qualität des Druckerzeugnisses weist mindestens eine Bildaufnahmeeinheit 48, insbesondere eine Kamera 48, vorzugsweise ein Farbzeilenkamerasystem, auf. Das Farbzeilenkamerasystem verwendet vorzugsweise eine Farbzeilenkamera 48 mit z. B. 2.048 Bildpunkten pro Bildzeile. Das Inline-Inspektionssystem zur Beurteilung der Qualität der von der Druckmaschine produzierten Drucksache ist für die Inline-Inspektion und eine Inline-Farbregelung bei Mittelformatmaschinen (Schöndruck) ausgelegt. Inline-Inspektion bedeutet, dass ein Bedruckstoff während seines Transports durch die Druckmaschine inspiziert wird. Das Inline-Inspektionssystem stellt sicher, dass eine vom Bediener definierte Qualität während des gesamten Produktionsprozesses gehalten wird.

Das Inline-Inspektionssystem zur Beurteilung der Qualität des von der Druckmaschine produzierten Druckerzeugnisses besteht im Wesentlichen aus drei Komponenten: mindestens einer Bildaufnahmeeinheit 48, einer Kamera- und Beleuchtungselektronikeinheit und einem Schaltschrank mit einem Bildverarbeitungssystem.

Die Bildaufnahmeeinheit 48 wird in die Druckmaschine eingebaut. Sie weist z. B. eine Farbzeilenkamera 48, eine Konstantlichtbeleuchtung oder alternativ eine Blitzlichtbeleuchtung, insbesondere eine getriggerte Linienbeleuchtung, auf, wobei sowohl die Konstantlichtbeleuchtung als auch die Blitzlichtbeleuchtung jeweils mehrere nebeneinander, d. h. zeilenförmig, angeordnete Lichtquellen aufweisen, wobei die Beleuchtungseinrichtung jeweils z. B. mit Wasser gekühlt ist, und einen Drehgeber, wobei der Drehgeber z. B. eine Auflösung von 10.000 Strichen hat.

Die Kamera- und Beleuchtungselektronikeinheit umfasst alle notwendigen Funktionseinheiten zur Leistungsversorgung der Beleuchtungseinheit und der Signalaufbereitung der Kamera. Diese Einheit wird in der Nähe der Bildaufnahmeeinheit 48 an einem geeigneten Ort untergebracht. Sie stellt eine homogene Ausleuchtung des durch die Druckmaschine transportierten Bogens sicher. Mit Hilfe einer Lichtmessfunktion wird während des Maschinenlaufs z. B. zyklisch geprüft, ob die Leuchtmittel einwandfrei, d. h. in ihrem vorgesehenen Arbeitsbereich funktionieren.

Der Schaltschrank mit dem Bildverarbeitungssystem umfasst insbesondere z. B. eine Stromversorgung des Bildverarbeitungssystems sowie einen Bildverarbeitungsrechner vorzugsweise inklusive einer Schnittstelle für die Bedienung zu einem Leitstandrechner (TCP/IP) sowie der Anschlussmöglichkeit eines Monitors, z. B. eines Farbmonitors, zur Überwachung der Druckprodukte und Fehleranzeige im laufenden Betrieb. Bei Widerdruck ist zudem eine Monitorumschaltung vorgesehen.

Für eine Bedienung des Systems zur Beurteilung der Qualität der von der Druckmaschine produzierten Drucksache kann eine Bedienoberfläche zunächst vorübergehend auf einem zweiten PC realisiert sein, bevor die Bediensoftware bei einem Serienprodukt in einem der Druckmaschine zugeordneten Leitstand integriert wird.

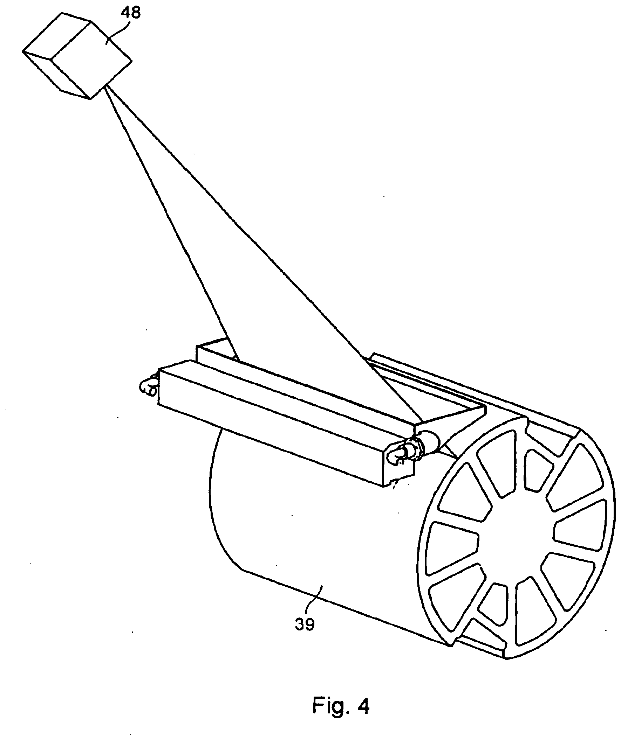

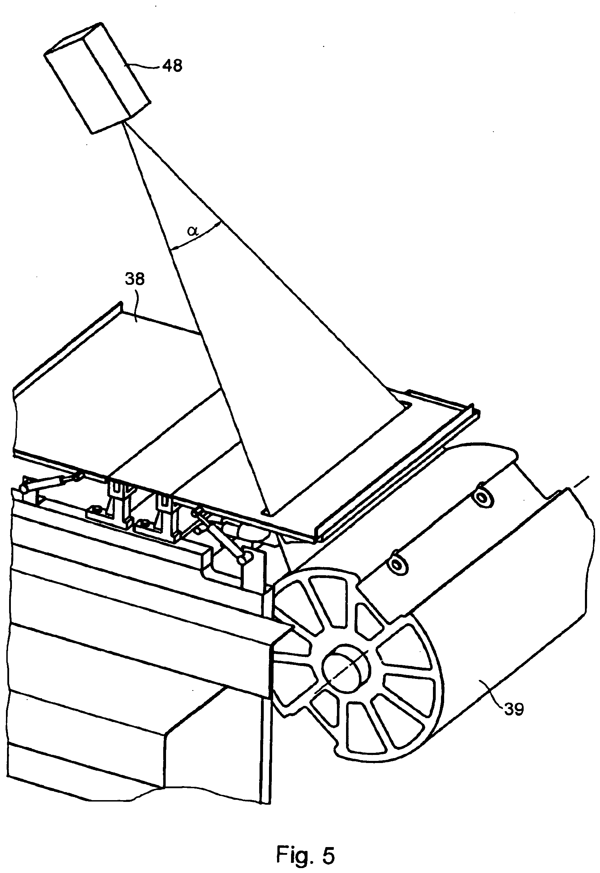

Einzelheiten zur Anordnung der Prüfeinrichtung 10; 11 bzw. des Inline-Inspektionssystems innerhalb der Bogendruckmaschine zeigen die Fig. 3 bis 5. Eine vorzugsweise nahe einem Druckwerkszylinder 39, z. B. einem Gegendruckzylinder 39, angeordnete Beleuchtungseinrichtung 46 erzeugt vorzugsweise einen Beleuchtungsstreifen 41 auf einem vom Druckwerkszylinder 39 transportierten Bogen 02. Dabei ist die Beleuchtungseinrichtung 46 vorzugsweise innerhalb eines einen Teil des Druckwerks 01 der Druckmaschine umgebenden Schutzes 38, z. B. unterhalb einem Fußtritt 38 im Galeriebereich der Druckmaschine angeordnet. Vom Beleuchtungsstreifen 41 remittiertes Licht wird von einer zum Druckwerkszylinder 39 beabstandet angeordneten Kamera 48 innerhalb eines bestimmten Erfassungswinkels α erfasst. Die Kamera 48 erfasst vom Beleuchtungsstreifen 41 remittiertes Licht vorzugsweise durch einen vorzugsweise schmalen Spalt oder Schlitz in dem den Druckwerkszylinder 39 abdeckenden Schutz 38 oder Fußtritt 38, wobei sich dieser Spalt oder Schlitz quer zur Transportrichtung des Bedruckstoffes 02 erstreckt.

An eine Grafikkarte eines Bildverarbeitungssystems wird ein so genannte Fehlermonitor angeschlossen. Dieser zeigt ein Live-Bild der Kamera 48. Die Druckfehleranzeige wird in das Kamerabild eingeblendet, sodass der Bediener sofort in der Lage ist, den Fehlerort und gegebenenfalls die Fehlerursache zu lokalisieren. Der Fehlermonitor zeigt sowohl auf dem Bedruckstoff 02 kurzzeitig auftretende Druckfehler, z. B. Farbspritzer, Wasserflecken oder Papierfehler, als auch dauerhafte Druckabweichungen, z. B. eine Über- oder Unterfärbung einzelner Druckfarben oder ein Tonen, an.

Im Inline-Inspektionssystem zur Beurteilung der Qualität einer von der Druckmaschine produzierten Drucksache ist ein Prozess-Lernmodus integriert, welcher in der Lage ist, den aktuellen Qualitätsstandard automatisch während der Gutproduktion zu erlernen. Die Programmierung eines Modells ist also nicht notwendig. Mit Hilfe des Prozess-Lernmodus werden Referenzen insbesondere für das Farbmodell und das Intensitätsmodell erzeugt, die zum Vergleich für die Inspektion und Farbbestimmung herangezogen werden. Der Lernmodus umfasst insbesondere folgende Funktionen: Lernen von Referenzen, Erweitern gelernter oder gespeicherter Referenzen, Eingabe der Anzahl der gewünschten Lernbogen, Definieren des Fensters des Inspektionsbereiches, Zeigen des gelernten oder gespeicherten Referenzbildes, Eingabe der Maske für einen nicht inspizierten Bildbereich, Bearbeiten des Referenzbildes, Editieren und Kopieren von Masken.

Durch die Druckmaschine transportierte Lernbogen werden ausgeschleust, um eine Kontrolle von einem eventuell eingelernten Druckfehler, eine Vermessung mit einem Handspektrometer oder eine visuelle Überprüfung möglich zu machen. Die Referenzmodelle sowie alle anderen relevanten Daten werden in einem Auftragsspeicher abgelegt. Es ist jederzeit möglich, für Wiederholaufträge den Auftragsspeicher zu lesen.

Darüber hinaus ist das Inline-Inspektionssystem in der Lage, zulässige Änderungen im Fortdruck, die vom Inline-Inspektionssystem als Fehler gewertet werden, bei laufender Produktion hinzuzulernen. Das Inline-Inspektionssystem passt sich somit adaptiv an den aktuellen Qualitätsstandard an und steuert oder regelt z. B. das Farbwerk und/oder ein Seiten- und/oder Umfangsregister der Druckmaschine.

Das menschliche Auge ist in der Lage, relativ kleine Farbänderungen zu detektieren.

Jedoch ist die Farbwahrnehmung des Menschen auf eine Detektion von Flächen ausgelegt. Kleine punktförmige Farbänderungen werden nicht detektiert. Das Farbanalyse-Modell berücksichtigt diesen physiologischen Effekt. Es werden die den Farbraum der Kamera 48 aufspannenden Farben Rot, Grün und Blau in einen Farbraum transformiert, der als Gegenfarbenmodell bezeichnet wird. Das Gegenfarbenmodell entspricht einer elektronischen Nachstellung der menschlichen Farbwahrnehmung. Darin existieren zwei Gegenfarbenkanäle, die äußerst empfindlich auf Farbänderungen reagieren. Insbesondere wird ein Kippen der Graubalance von diesen Kanälen zuverlässig erkannt.

Das Gegenfarbenmodell kann auch auf der Basis der Offsetdruckfarben CMYK implementiert sein, wobei dieses Farbmodell gegenüber dem empfindungsgemäßen Farbmodell auf ein subtraktives Farbenmischen (Druckverfahren) ausgerichtet ist.

Intensitätsabweichungen, d. h. Änderungen der Farbdichte, werden über eine Grauwertanalyse detektiert. Dieses Verfahren hat insbesondere in Bereichen unbunter Farben, bei einer Über- und Unterfärbung sowie bei kleinen Fehlern, z. B. kleine Farbspritzer oder Papierfehler, seine Stärken.

Das Farbwerks zum Dosieren der Menge der auf den Bedruckstoff 02 zu übertragenden Druckfarbe kann in Axialrichtung eines Formzylinders eines Druckwerks der Druckmaschine mehrere, z. B. mindestens zwischen 25 und 60 Zonen aufweisen, wobei die Dosierung der auf den Bedruckstoff 02 zu übertragenen Druckfarbe in unterschiedlichen Zonen unterschiedlich einstellbar ist. Die Dosiereinrichtung des Farbwerks kann z. B. steuerbare Zonenschrauben aufweisen, wobei in einer im Mehrfarbendruck druckenden Druckmaschine insgesamt mehrere hundert jeweils einzeln steuerbare Zonenschrauben vorgesehen sein können. Die Dosiereinrichtung dosiert eine Menge der auf den Bedruckstoff 02 zu übertragenden Druckfarbe durch eine Einstellung ihrer Schichtdicke und/oder ihrer Auftragungsdauer. So kann die Dosiereinrichtung auch als ein mindestens eine Farbpumpe verwendendes Farbzufuhrsystem, z. B. als ein Pumpfarbwerk, ausgebildet sein, wobei Druckfarbe an einen Farbduktor eines Farbwerks herangeführt wird und am Farbduktor vorzugsweise zonenweise mittels individuell auf die verschiedenen Farbzonen wirkender Stellmittel dosierbar ist, wobei die Stellmittel z. B. ein von mindestens einem elektrisch betätigbaren Stellantrieb antreibbares Farbdosiermittel, z. B. mindestens ein Farbmesser oder einen Farbschieber, aufweisen, wobei der Stellantrieb z. B. als ein von einer Steuereinheit steuerbarer Stellmotor ausgebildet ist. Das Farbwerk kann als ein aus vielen Walzen bestehendes Walzenfarbwerk oder als ein Kurzfarbwerk ausgebildet sein. Alternativ kann das Farbwerk auch als ein Druckfarbe zerstäubendes, vorzugsweise Druckfarbe zonal auf einen Farbduktor auftragendes Sprühfarbwerk ausgebildet sein.

Eine Farbregelung kann je nach den im konkreten Fall vorliegenden Voraussetzungen nach zwei verschiedenen Verfahren erfolgen. Wenn Farbmessstreifen mit ausreichend großen Farbfeldern vorhanden sind, werden gemäß dem Schema zur Farbdichteregelung mit einem Farbmessstreifen zunächst die Solldichten für die einzelnen Farben eingegeben. Die Position des Messkontrollstreifens wird vom Bediener am Monitor markiert. Danach werden die Felder des Streifens automatisch in Bezug auf Skalenfarben analysiert und die jeweilige Istdichte bestimmt. Sonderfarben sind vom Bediener im Messstreifen zu markieren. Anhand der Abweichungen von einer Solldichte und der vorliegenden Istdichte werden die Farbzonen an einem Farbwerk der Druckmaschine gestellt. Die jeweiligen Abweichungen werden grafisch und numerisch angezeigt. Vom Inline-Inspektionssystem werden Vorschlagswerte für die Farbzonenstellung angegeben. Diese können wahlweise manuell übernommen oder vollautomatisch im geschlossenen Regelkreis verwendet werden. Mit Hilfe der Farbmessstreifen kann mit Hilfe der Rasterfelder auch eine Tonwertzunahme bestimmt werden.

Die Algorithmen zur Dichtebestimmung in Farbmessstreifen können für jeden Bogen 02 durchlaufen werden. Auch eine gleitende Mittelwertbildung der Messwerte über eine beliebige Bogenanzahl ist möglich. Messungenauigkeiten, die durch den Einfluss von Schwankungen des Drucks, durch ein Rauschen der Kamera 48, z. B. ein Photonenrauschen oder ein Quantisierungsrauschen des AD-Wandlers, oder durch eine Instabilität der von der Beleuchtungseinrichtung abgestrahlten Lichtmenge entstehen, werden auf diese Weise zuverlässig eliminiert oder zumindest in ihrem Störeinfluss minimiert.

Eine Kalibrierung des Dichtemesssystems erfolgt mit Messbogen, die in regelmäßigen Abständen durch die Maschine gefahren werden. Bei der Kalibrierung wird automatisch eine Farbbalance, ein Kontrast und eine Helligkeit justiert. Weiterhin kann das Normlicht für die Messung festgelegt werden, z. B. wie üblich D50 oder D65. Eine Re-Kalibrierung ist in der Praxis zumeist nicht häufiger als einmal pro Woche nötig.

Der Messstreifen weist eine Feldbreite und eine Feldhöhe jeweils z. B. von ca. 5 mm bis 6 mm auf. Die Messfeldgröße, die ein 2° Normbeobachter benötigt, muss im Messfeld sicher untergebracht werden. Der Messstreifen besteht aus mehreren gleichen Segmenten, wobei ein regelmäßiger Aufbau innerhalb eines Segmentes erfolgt.

Ein anderes Verfahren zur Farbregelung sieht eine Farbbestimmung und Farbregelung anhand des Druckbildes vor. Voraussetzung dafür ist vorzugsweise, dass die Flächendeckung pro Druckfarbe mit einer Auflösung von 10 < dpi < 40 aus einer Vorstufe, z. B. CIP3, bekannt ist, und dass "signifikante" Druckbereiche pro Farbzone- oder Farbzonenbereich vorhanden sind. Signifikant sind Druckbereiche dann, wenn eine der Druckfarben in diesem Bereich dominant ist. Die Bestimmung der signifikanten Druckbereiche erfolgt automatisch durch Auswertung von Daten aus der Vorstufe.

Die Farbbestimmung und die Ableitung von Stellgrößen für die Farbregelung erfolgt anhand des Druckbildes selbst. Hierzu wird eine Transformation der Kamerabilddaten in den CMYK-Raum durchgeführt.

Die Analyse des Druckbildes erfolgt anhand einer Farbintegration der signifikanten Druckbereiche innerhalb von Längsstreifen, die in ihrer Anzahl vorzugsweise der Anzahl der Zonenschrauben entsprechen. Diese Streifen sind nochmals horizontal aufgeteilt. Innerhalb dieser so entstandenen Flächen wird anhand der Farbänderungen und der Zonendichte die entsprechende Zone gestellt. Durch entsprechende Mittelung über mehrere Bogen 02 werden zulässige Prozessschwankungen ausgeglichen.

Eine aus der Messung berechnete Regelabweichung für die Farbgebung wird für jede Farbzone in einen Stellbefehl zur Ansteuerung der betreffenden Zonenschraube umgesetzt.

Eine Änderung der Farbzufuhr innerhalb der Druckmaschine benötigt eine gewisse Zeit, bevor diese im Druckbild sichtbar wird. Dieses Verhalten ist durch die Art der Farbübertragung in der Druckmaschine begründet. Um diesen Vorgang zu beschleunigen, wird als Regler ein Integralregler mit einem Proportionalanteil, kurz PI-Regler, vorgesehen. Dieser Regler hat den Vorteil, dass zusätzlich zu einem stationären Anteil (I-Anteil) für eine gewisse Zeit ein fehlerproportionaler Anteil für eine zusätzliche/verminderte Farbzufuhr sorgt und so den Regelvorgang beschleunigt.

Die durch den Proportionalanteil verursachte zusätzliche oder verminderte Farbzufuhr wird vereinfacht für eine gewisse Zeit, d. h. für eine gewisse Anzahl von Zylinderumdrehungen, zugelassen. Nach Ablauf dieser Zeit werden alle Farbzonen auf den stationären Zustand gefahren.

Weiterhin wird der Regelkreis dahingehend vereinfacht, dass ein zyklisches Verfahren mit den Schritten Messen, Stellen und Warten realisiert wird. Nach Abschluss der Wartezeit, d. h. nach einer gewissen Anzahl von Zylinderumdrehungen, wird mit einer neuen Messung ein neuer Zyklus gestartet. Es handelt sich also trotz des geschlossenen Regelkreises um ein offenes Wirkungsprinzip, da die maßgebliche Zeitkonstante durch die Zeit zwischen Stellung der Zonen und einer Reaktion auf dem Papier festgelegt ist. Da diese Zeit z. B. proportional zu einigen zehn Bogen ist, ist hier ein offenes Wirkungsprinzip realisiert. Weiterhin wird die Regelung selbst als Lageregelung ausgeführt, d. h. die Öffnung der einzelnen Zonen wird gestellt und für eine gewisse Zeit in dieser Stellung gehalten. Um schnellstmöglich die Solldichte zu erreichen, wird zugelassen, dass im Fall einer Farbzufuhr die Zonen gegebenenfalls für eine gewisse Zeit überregelt werden.

Während des Fortdrucks kann der Bediener manuell Korrekturwerte, d. h. Sollwerte, für die Zonenschrauben eingeben. Diese Änderungen werden im Signalfluss wie eine Regelabweichung behandelt.

Im Regelalgorithmus werden alle die Farbgebung beeinflussenden Parameter integriert. Hierzu zählen insbesondere das Farbverhalten, d. h. eine Deckung der Farbe, das Papierverhalten sowie das Farbübertragungsverhalten des Farbkasten. Hierbei sind die Farbe und das Papier auftragsabhängige Parameter.

Im Folgenden wird weiter auf den Aufbau des Inline-Inspektionssystems eingegangen. Die vorzugsweise digital arbeitende Bildaufnahmeeinheit 48 umfasst z. B. eine speziell für eine Druckmaschine entwickelte Beleuchtungseinheit und eine Farb-CCD-Zeilenkamera. Das Objektiv ist speziell an die hochauflösende Kamera 48 angepasst, weist einen abnehmbarem Filter, z. B. einen UV-Filter als Objektivschutz auf und kann bedienerfreundlich justiert werden. Im Servicefall kann die Kamera 48 sowie das Objektiv einfach ausgetauscht werden. Die Bildaufnahmeeinheit 48 ist gegen mechanische und elektromagnetische Störungen geschützt. Zur Beleuchtung werden z. B. speziell für diesen Anwendungsfall entwickelte hochfrequenzgetaktete Beleuchtungsquellen verwendet. Die Anordnung der Leuchtmittel innerhalb der Beleuchtungseinheit ist z. B. speziell für die Applikation im Bogendruck angepasst. Die Leuchtmittel können einfach getauscht werden.

Das Bildaufnahmemodul (Frame Grabber) setzt das eingehende Videobild in einen digitalen Videostrom um. Dieser Videostrom wird im Frame Grabber einer Helligkeitsanpassung (Shading-Korrektur), einer wahrnehmungsorientierten Farbanpassung und der Farbraumtransformation unterzogen. Dieser digitale Videostrom wird zur späteren Bearbeitung im Speicherbereich des Bildaufnahmemoduls abgelegt. Die Bildaufnahme und Bildauswertung wird in Maschinen-Echtzeit durchgeführt.

Das Inline-Inspektionssystem ist z. B. mit einer Positionierungseinheit ausgestattet, die in der Lage ist, eine Bildpositionierung vorzunehmen. Durch Unschärfen in der Transportbewegung des Bogens 02 kann es notwendig sein, das aufgenommene Druckbild für jede Aufnahme im Inline-Inspektionssystem zu positionieren. Während des Lernprozesses wird automatisch im Inline-Inspektionssystem eine Referenzposition für jeden Bogen ermittelt.

In einem Lernmodus nimmt das Inline-Inspektionssystem während der Produktion Bogen 02 mit der CCD-Kamera auf und bildet ein Computermodell mit allen Varianten einer akzeptablen Druckqualität. Ausgehend von einer korrekten Farbeinstellung werden in der Lernphase Druckbogen oder Druckexemplare erfasst, analysiert und ausgewertet. Der Lernmodus ist in der Lage, Referenzen in Maschinen-Echtzeit zu generieren. Nach dem Lernen schaltet das Inline-Inspektionssystem automatisch in den Farbmess- und Inspektionsmodus um. Mit Hilfe der erlernten Referenzen wird die aktuelle Produktion nunmehr geprüft. Es ist allerdings zu jeder Zeit möglich, einen Standard innerhalb des Referenzenspeichers durch Dazulernen zu erweitern.

Es werden mehrere Bogen 02 erfasst und ausgewertet. Das RGB-Signal der Videokamera wird in die Farbauszüge CMYK umgerechnet. Jeder Farbauszug wird in Streifen, entsprechend der Farbzonen, unterteilt. Innerhalb jeder Zone wird der Flächenanteil des betreffenden Farbauszuges bestimmt. Dieser Wert wird über die erfassten Bogen 02 gemittelt. Der gemittelte Wert jedes Flächenanteils aus der Lernphase wird als Sollwert für die Kontrollphase übernommen.

In dem Inspektionsmodus wird jedes Bild mit den Analyse-Modellen und Referenzen verglichen. Die Empfindlichkeit des Inline-Inspektionssystems kann vom Bediener mittels weniger Inspektionsparameter, wie z. B. der Grauwert- und Farbtoleranzen sowie Fehlergrößen, auf die individuellen Bedürfnisse eingestellt werden. Der Inspektionsmodus umfasst z. B. folgende Funktionen: Endlosinspektion des laufenden Produktionsauftrages, Eingabe von Toleranzen für die Inspektion, Definieren eines Gitternetzes für die horizontale und vertikale Aufteilung des Inspektionsbildes. Die Eingabe von Inspektions-Parametern, die das Inline-Inspektionssystem beeinflussen, kann wahlweise durch ein "Password" gesichert werden. Das "Password" kann geändert werden oder es können mehrere benutzerspezifische "Passwords" vergeben werden. Während der Inspektion können z. B. bis zu 96 Einzelnutzen durch das Inspektionssystem-Gitternetz getrennt statistisch erfasst werden. Fehlernutzen werden durch einen Gitterrahmen, der den optischen Verhältnissen angepasst ist, gekennzeichnet.

Alle gespeicherten variablen Eingabedaten bleiben beim Abschalten und Wiedereinschalten des Inline-Inspektionssystems erhalten. Alle Eingabedaten und Produktionsabläufe werden in einem Logfile gespeichert. Dieses Logfile stellt grundsätzliche Daten bei einem Stromausfall für die Statistik wieder zur Verfügung.

Der Fehleranalyse-Prozessor analysiert den Bildvergleich, der vom Bildprozessor generiert wurde. Er erzeugt ein Fehlerbild, welches in das Live-Bild des Fehlermonitors eingeblendet wird. Dieses erlaubt dem Bediener, sofort nach Analyse des Bildes in den Maschinenprozess einzugreifen.

Auf einem Leitstandrechner wird ein Mensch-Maschine-Interface implementiert, dessen sämtliche Verbindungen vorzugsweise über Optokoppler erfolgen. Die Schnittstelle ist z. B. eine Ethernet-Verbindung mit TCP/IP.

Das Inline-Inspektionssystem ist vorzugsweise mit einem Festplattenspeicher ausgestattet, der über genügend Kapazität verfügt, um verschiedene Aufträge inklusive aller Toleranzen und Statistiken abzuspeichern. Dieser Auftragsspeicher ist z. B. für ca. 2.000 Aufträge ausgelegt. Durch eine Festplattenerweiterung kann die Anzahl der Aufträge entsprechend erhöht werden.

Während des Lernprozesses wird anhand der Modelle festgestellt, ob ein einzulernender Bogen 02 im großen Maße fehlerbehaftet ist. Sollte dies der Fall sein, wird der Bogen 02 nicht miteingelernt, also nicht mit in das aktuelle, einen Qualitätsstandard definierenden Referenzbild aufgenommen. Dieser adaptive Prozess sorgt dafür, dass keine unakzeptablen Bogen 02 in ein Referenzbild eingelernt werden.

Der Bildvergleich wird in Maschinen-Echtzeit z. B. bis zu einer Geschwindigkeit von 18.000 Bogen pro Stunde durchgeführt.

Ein Fehler in der Qualität einer von der Druckmaschine erzeugten Drucksache, z. B. eine Über- oder Unterfärbung, Farbabweichungen und geometrische Effekte, wird in Bezug auf wahrnehmungsorientierte Fehlergrößen detektiert. Die Farbabweichungen führen zu einem Abweichungsmaß, das zur Stellung der Zonenschrauben genutzt wird. Eine Abweichung in der Farbdeckung von weniger als 10% wird nicht geregelt. Die Kamera garantiert eine 100 %-ige Detektion des gesamten Bogens.

Zur Bedienung des Inline-Inspektionssystems sind folgende Einstellungen vornehmen:
- Solldichten
- Position des Messkontrollstreifens
- Druckwerkszuordnung der Farben
- Grauwertempfindlichkeit
- Farbkanalempfindlichkeit
- Fehlergrößen

Bei der Inspektion können Fehler im Kontrast und in der Größe definiert werden. Die Fehlergröße kann minimal einen Bildpunkt betragen.

Das Maschineninterface übermittelt einen Alarm, wenn ein oder mehrere hintereinander folgende Bogen 02 mit Druckfehlern identifiziert worden sind. Hierbei wird unterschieden, ob es sich um eine Farbabweichung handelt, die zu einer Zonenschraubenverstellung führt, oder ob es sich um einen geometrischen Fehler handelt, d. h. einen Kurzzeitfehler.

Auch stehen z. B. an SPS-Ausgängen Informationen zur Verfügung, ob ein Gut- oder Schlechtbogen vorliegt, das Inline-Inspektionssystem aktiv ist oder sich im Lernmodus befindet.

Zur genauen Analyse eines fehlerhaften Bogens 02 stehen zwei Modi zur Verfügung, wobei in einem Modus das Inline-Inspektionssystem nach einem Fehler stoppt und in dem anderen Modus das Inline-Inspektionssystem nur vorübergehend anhält. Im Stop-nach-Fehler-Modus wird das Bild des Bogens 02 inklusive der Fehleranzeige eingefroren, sobald das Inline-Inspektionssystem einen Fehler auf einem Bogen 02 detektiert. Der Bediener kann die Fehleranzeige in Ruhe betrachten und bewerten und eventuell mit zugehörigem Druckbogen verifizieren. Das eingefrorene Bild muss per Tastendruck wieder freigegeben werden. Die Inspektion läuft im Hintergrund weiter. Im Modus Stop-und-Weiter wird das Bild nach einer Fehlerdetektion automatisch eingefroren und nach einer einstellbaren Dauer von z. B. ca. 15 Sekunden automatisch wieder freigegeben. Der Bediener erhält somit die Möglichkeit, das Bild eine gewisse Zeit zu betrachten, ohne gezwungen zu sein, das Inline-Inspektionssystem manuell wieder freizuschalten.

Während der Produktion wird jeder Bogen 02 analysiert und eine Gut-, Warnung- und Schlechtbogen-Statistik geführt. Weiterhin werden alle relevanten Parameter einer Produktion mit aufgezeichnet und in das Statistikmodul überführt. Da Statistiken auf einem PC geführt werden, ist es möglich, diese mit handelsüblichen Programmen weiter zu verarbeiten.

Das Inline-Inspektionssystem detektiert zumindest Druckfehler, die während der Produktion entstehen, wenn der Druckfehler einen Farbmessfehler mit einer Farbabweichung ΔE >= 3 und eine Dichtefehlergenauigkeit ΔD > 0.02 aufweist. Als Inspektionsfehler gelten Farbfehler z. B. durch Über- oder Unterfärbung, Spritzer oder Butzen und Registerfehler mit einer Größe von ca. 0,025 mm². Des Weiteren können Papierfehler, Falten, Papiereinschlüsse, Verschmutzung oder Öl erkannt werden. Da 100 % des Bogens kontrolliert werden, können auch Fehler, die in vorherigen Prozessen entstanden sein könnten, detektiert werden. Das Inline-Inspektionssystem kann jede Bogengröße mit einer Kantenlänge z. B. bis zu 740 mm x 1.050 mm inspizieren.

Verschiedene Fehlertypen wie Flächenfehler, Peak-Fehler, Überfärbung, Unterfärbung oder Farbfehler können auf dem Fehlermonitor durch unterschiedliche Symbole angezeigt werden.

Toleranzwerte der einzelnen Bearbeitungsbereiche eines Referenzbildes können numerisch angezeigt werden und, falls erforderlich, geändert werden. Die Mindestanzahl der Bildpunkte, die für eine Fehlerfläche außerhalb des Toleranzbereiches als Fehler auftreten, kann eingegeben werden.

Im Folgenden wird auf das Bedienkonzept des Inline-Inspektionssystems eingegangen. Das Inline-Inspektionssystem soll eine einfache und schnelle Bedienung erlauben, die dem Drucker bei geringem Schulungsaufwand einen großen Nutzen bringt. Er muss frühzeitig auf eine sich aufbauende Abweichung hingewiesen werden, bevor Makulatur erzeugt wird.

Die Bedienung existiert als eine Task auf dem Maschinenleitstand, die sich in das übergeordnete Bedienkonzept der Maschine einfügt. Für die Betrachtung eines aktuellen Fehlerbildes steht ein zusätzlicher Monitor zur Verfügung. Bei einer Widerdruckmaschine ist das Bild umschaltbar. Die über den Inspektionsbetrieb hinausgehenden Funktionen, wie z. B. für das Einrichten eines Auftrags oder eine Erstellung von Masken, sind z. B. über entsprechende Einsprungpunkte in der existierenden, im Maschinenleitstand implementierten Bediensoftware der Maschine erreichbar.

Die Bildaufnahme erfolgt vorzugsweise, während sich der zu inspizierende Bedruckstoff 02, z. B. Bogen 02 oder Bahn auf einem Druckzylinder der Druckmaschine befindet. Die Bildaufnahme ist hier sehr stabil. Je nach Material, z. B. bei sehr dünnem Papier, kann es jedoch zu einer Faltenbildung oder z. B. bei einem biegesteifen Karton zu einem Ablösen des Bogenendes auf der Mantelfläche des Druckzylinders kommen. Die Bildaufnahme ist beim Einbau mechanisch zu kalibrieren, sodass bekannte mechanische Randbedingungen direkt in die Pixeldimension der Bildaufnahme umzusetzen sind.

Ein Datenfluss zum oder vom Maschinenleitstand sieht vor, dass ein Auftragsname, eine Loadnummer oder der Durchgang direkt vom Maschinenleitstand übernommen werden, um für die Jobverwaltung des Inline-Inspektionssystems genutzt zu werden. Aus den Bogenabmessungen kann das übergeordnete Inspektionsfenster generiert werden. Das manuell betätigte Gutbogensignal an der Maschine kann für die Aktivierung der Inspektion und auch für die statistische Auswertung genutzt werden. Ein von dem Inline-Inspektionssystem generierter "Gutbogenzähler" kann gegebenenfalls der Maschinenleitstandsstatistik zugeführt werden.

In einem Datenfluss zur Druckmaschine sind Signale für die Ansteuerung einer Ausschleusung oder einer Bogenmarkierung zu erzeugen, um die Bogen 02 wahlweise im Ablagestapel 08 oder im Ablagestapel 09 abzulegen.

Die Akzeptanz des Inline-Inspektionssystems durch den Bediener wird durch eine konsistente Integration in das Gesamtkonzept der Maschinenbedienung und die Beschränkung auf einen minimal nötigen, überschaubaren Funktionsumfang gefördert. Deshalb wird das Look-and-Feel der Bedienung stark an das Aussehen und an die Funktionalität der Maschinenleitstandsoftware angelehnt. Die Bedienschritte zum Einrichten eines Auftrages sind in ihrem Umfang gering gehalten. Beim Fortdruck gibt es einen direkten Zugriff auf Schlüsselfunktionalitäten über Funktionstasten/Hardkeys durch die Leitstand-Bediensoftware.

Das Einrichten eines neuen Auftrags wird durch die Übernahme von möglichst vielen relevanten Daten aus dem Leitstandrechner einfach gehalten. Zu übernehmende Daten wären z. B. ein Auftragsname, eine Jobnummer, eine Loadnummer, ein aus dem Papierformat abgeleiteter Inspektionsrahmen oder eine Nutzenaufteilung, z. B. aus einem CF2-File einer Stanzkontur.

Manuelle Eingaben, die für den Drucker einen Aufwand bedeuten, werden auf die Eingabe des Positionierungsfensters begrenzt. Das Inspektionsfenster kann auch automatisch gesetzt werden, wobei es dann nicht notwendig ist, die Druckmaschine schon zum Einrichten des Jobs anfahren zu müssen. Das Lernen kann dann - bei aktivem Gutbogensignal - automatisch gestartet werden.

Inspektion und Leitstandsoftware teilen sich einen Bedienmonitor. Im Fortdruck wird die Leitstandsoftware angezeigt; für einen Minimalaufwand bei der Bedienung des Inline-Inspektionssystems stehen Hardkeys oder Funktionstasten in den Leitstandssoftware-Masken zur Verfügung, z. B. für die Funktionen Umschaltung Vorder-/Rückseite, Live/Stop&Go/StopOnError oder "Freeze".

Durch eine Funktionstaste (Soft-Key) kann außerdem die vom Look-and-Feel an die Leitstandsoftware angepasste Inspektions-Bedientask aktiviert werden; hierdurch steht dann die volle Bedienbarkeit des Inline-Inspektionssystems zur Verfügung. In diesem Modus werden bezüglich der Bedienung der Druckmaschine nur die Statusinformationen, die z. B. in einem oberen Statusfenster angezeigt werden, dargestellt.

Einstellungen, die in der Inspektions-Bedienoberfläche über die - analog zur Leitstandsoftware implementierte - Funktionstastenreihe vorzunehmen sind, betreffen z. B. Toleranzen, das Lernen/Zulernen, das Erstellen von Masken, eine Anpassung der Nutzeneinteilung, eine Anpassung des Inspektionsrahmens, eine Re-Definition des Positionierungsfensters oder das Laden oder Betrachten von Bildern.

Der Live-Monitor kann Fehleranzeigen im Farbbereich CMYK oder Sonderfarben durch entsprechende Farbanzeige anzeigen.

Zusätzliche Bedienelemente in der Leitstandsoftware können eine Korrektur eines Nettozählers durch das Inspektionsergebnis, eine Fehlerbogenstatistik oder eine Ampelanzeige der Inspektion im Maschinenstatusfeld vorsehen.

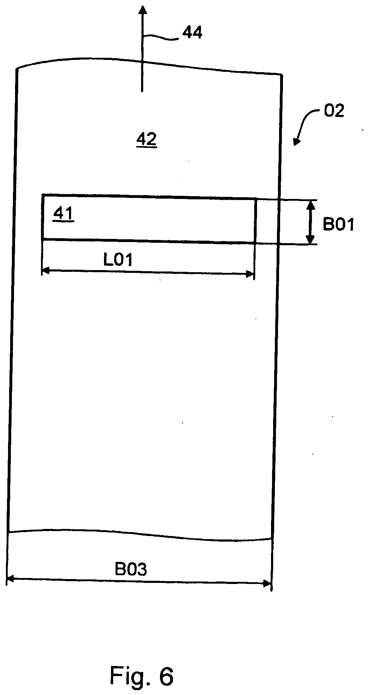

In der zuvor beschriebenen Druckmaschine, vorzugsweise in einer Rotationsdruckmaschine, insbesondere in einer in einem Offsetdruckverfahren druckenden Druckmaschine, wird ein in der Fig. 6 dargestellter Bogen 02 mit einer Oberfläche 42 in einer durch einen Pfeil angedeuteten Bewegungsrichtung 44 bewegt. Der Bogen 02 ist insbesondere als ein z. B. aus Papier bzw. Karton bestehender Bedruckstoff 02 ausbildet, insbesondere zur Herstellung von Etiketten oder Faltschachteln.

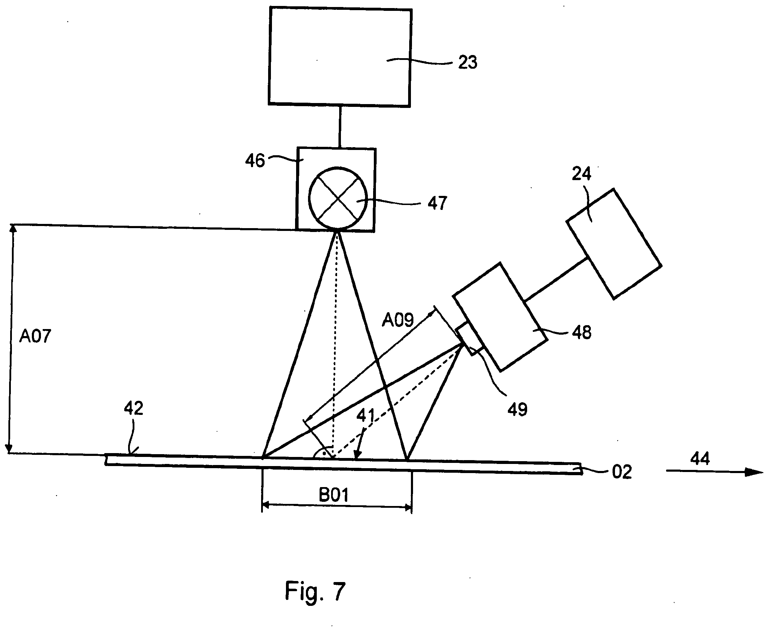

Eine in der Fig. 7 nur symbolhaft dargestellte Beleuchtungseinrichtung 46 erzeugt auf der Oberfläche 42 des Bogens 02 ein beleuchtetes Gebilde 41 in Form eines Beleuchtungsstreifens 41 mit einer Länge L01 und einer Breite B01 (Fig. 6), wobei sich die Breite B01 auf der Oberfläche 42 des Bogens 02 orthogonal zur Länge L01 erstreckt. Die Breite B01 des Beleuchtungsstreifens 41 ist vorzugsweise längs zur Bewegungsrichtung 44 des Bogens 02 gerichtet, wohingegen die Länge L01 des Beleuchtungsstreifens 41 vorzugsweise parallel zur Breite B03 des Bogens 02, d. h. quer zur Bewegungsrichtung 44 des Bogens 02, gerichtet ist und sich über Teile der Breite B03 des Bogens 02 oder über dessen gesamte Breite B03 erstrecken kann. Die Breite B01 des Beleuchtungsstreifens 41 beträgt vorzugsweise mindestens 3 mm, insbesondere 8 mm. Die Bewegungsrichtung 44 des Bogens 02 ist somit vorzugsweise zumindest im Wesentlichen parallel zur Breite B01 des Beleuchtungsstreifens 41 gerichtet, wobei die Bewegungsrichtung 44 des Bogens 02 innerhalb der von der Länge L01 und der Breite B01 des Beleuchtungsstreifens 41 aufgespannten Ebene liegt. Der Bogen 02 ist vorzugsweise zumindest im Bereich des Beleuchtungsstreifens 41 nicht gewölbt.

Die Beleuchtungseinrichtung 46 weist mehrere zeilenförmig nebeneinander angeordnete Lichtquellen 47 auf, sodass die gesamte Beleuchtungseinrichtung 46 zeilenförmig ausgebildet ist. Die zeilenförmig angeordneten. Lichtquellen 47 der Beleuchtungseinrichtung 46 sind vorzugsweise parallel zur Länge L01 des Beleuchtungsstreifens 41 angeordnet. Die Lichtquellen 47 haben zur Oberfläche 42 des Bogens 02 jeweils einen Abstand A07, wobei der Abstand A07 vorzugsweise zwischen 30 mm und 200 mm, insbesondere zwischen 80 mm und 140 mm beträgt. Der Abstand A07 der Lichtquellen 47 steht vorzugsweise jeweils lotrecht auf der Oberfläche 42 des Bogens 02. Alle Lichtquellen 47 der Beleuchtungseinrichtung 46 sind vorzugsweise gleichartig ausgebildet, z. B. als helle, lichtestarke Leuchtdioden 47 oder als Laserdioden 47. Eine zentrale Ebene des von den nebeneinander angeordneten Lichtquellen 47 der Beleuchtungseinrichtung 46 emittierten Lichtes und eine zentrale Ebene des vom Beleuchtungsstreifen 41 zur Kamera 48 remittierten Lichtes schließen einen vorzugsweise spitzen Winkel γ miteinander ein, der z. B. im Bereich zwischen 15° und 60°, insbesondere zwischen 20° und 30° liegt (Fig.3).

In der Beleuchtungseinrichtung 46 können auch Gruppen von jeweils mehreren zeilenförmig nebeneinander angeordneten Lichtquellen 47 vorgesehen sein, wobei sich die einzelnen Gruppen von Lichtquellen 47 in ihren optischen Eigenschaften, z. B. in der Wellenlänge des von ihnen emittierten Lichtes unterscheiden. So kann z. B. eine Gruppe von Lichtquellen 47 weißes Licht emittieren, wohingegen eine andere Gruppe von Lichtquellen 47 monochromes Licht emittiert. Es kann vorgesehen sein, dass eine mit der Beleuchtungseinrichtung 46 verbundene Steuereinrichtung 23 die Gruppen von Lichtquellen 47 applikationsabhängig, z. B. in Abhängigkeit von der Beschaffenheit der Oberfläche 42 des Bogens 02 nach der Farbe des Lichtes, ausgewählt und einzeln ansteuert. So kann die Steuereinrichtung 23 eine Gruppe von Lichtquellen 47 auch unabhängig von mindestens einer anderen Gruppe von Lichtquellen 47 in ihrer Helligkeit und/oder Leuchtdauer ansteuern. Der Beleuchtungsstreifen 41 ist außerhalb eines im direkten oder im umgelenkten Strahlengang liegenden Brennpunktes des von den Lichtquellen 47 emittierten Lichtes angeordnet.

Die Beleuchtungseinrichtung 46 besteht z. B. aus mehreren zeilenförmig aneinander gereihten Modulen jeweils mit vorzugsweise mehreren zeilenförmig nebeneinander angeordneten Lichtquellen 47, wobei eine Trennfuge 26 zwischen zwei benachbarten Modulen vorzugsweise schräg zur Länge L01 des Beleuchtungsstreifens 41 angeordnet ist. Die einzelnen Module der Beleuchtungseinrichtung 46 können z. B. funktionsgleich ausgebildet sein. So kann z. B. eine der Breite B03 des zu beleuchtenden Bogens 02 entsprechende Zeilenlänge der aus mehreren aneinander gereihten Modulen zusammengesetzten Beleuchtungseinrichtung 46 durch ein Einschalten von den zeilenförmig angeordneten Lichtquellen 47 der betroffenen Module aktiviert werden oder es kann eine der Länge L01 des Beleuchtungsstreifens 41 entsprechende Zeilenlänge der aus mehreren aneinander gereihten Modulen zusammengesetzten Beleuchtungseinrichtung 46 durch ein Einschalten von den zeilenförmig angeordneten Lichtquellen 47 der betroffenen Module aktiviert werden.

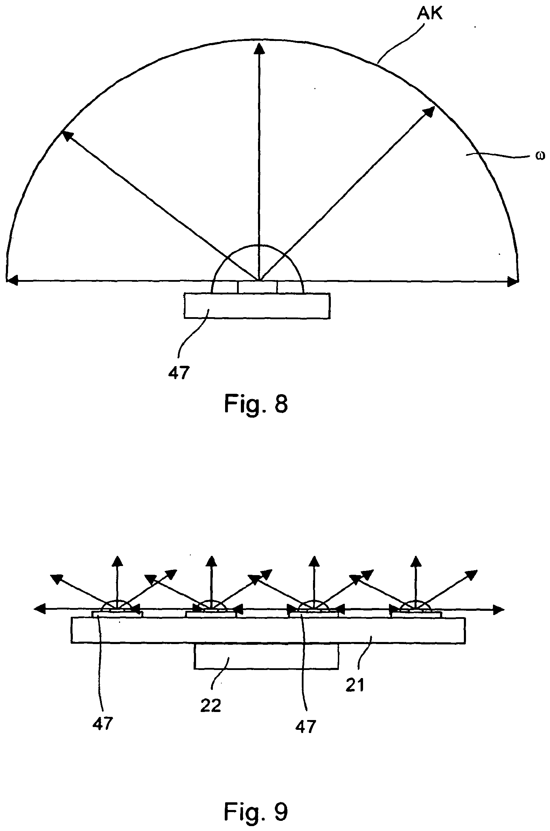

Fig. 8 zeigt in einer nur zweidimensionalen Darstellung eine einzelne Lichtquelle 47 der Beleuchtungseinrichtung 46. Die Lichtquelle 47 emittiert ihr Licht in einen Raumwinkel ω, wobei der Raumwinkel ω eine aus einer Kugel ausgeschnittene Fläche AK, also eine Kugeloberfläche AK, bis zur Größe einer Halbkugel aufspannt.

Fig. 9 zeigt mehrere, z. B. vier der in der Fig. 8 gezeigten Lichtquellen 47 zeilenförmig nebeneinander auf einer gemeinsamen Platine 21 angeordnet. Vorzugsweise ist die zu den jeweiligen Lichtquellen 47 gehörende Stromquelle 22 auf derselben Platine 21 angeordnet. Die Stromquelle 22 ist vorzugsweise als eine Konstantstromquelle 22, insbesondere als eine steuerbare Konstantstromquelle 22, ausgebildet.

Das optische Inline-Inspektionssystem umfasst - wie es der Fig. 7 entnehmbar ist - auch eine Erfassungseinrichtung 48 mit mindestens einem in einem Abstand A09 von der Oberfläche 42 des Bogens 02 angeordneten Detektor 49, wobei der Detektor 49 von der Oberfläche 42 des Bogens 02 remittiertes Licht erfasst. Der Abstand A09 liegt im Bereich zwischen 10 mm und 1.500 mm, vorzugsweise zwischen 50 mm und 400 mm. Die Erfassungseinrichtung 48 ist z. B. als eine Kamera 48, vorzugsweise eine Zeilenkamera 48, insbesondere eine Farbzeilenkamera 48, ausgebildet. Auch die Erfassungseinrichtung 48 kann zeilenförmig mehrere nebeneinander angeordnete Detektoren 49 aufweisen, wobei die zeilenförmig angeordneten Detektoren 49 vorzugsweise parallel zur Länge L01 des Beleuchtungsstreifens 41 angeordnet sind. Der Detektor 49 der Erfassungseinrichtung 48 kann z. B. als ein CCD-Array 49 oder als eine Gruppe von Photodioden 49 ausgebildet sein. Der Detektor 49 der Erfassungseinrichtung 48 wandelt das erfasste remittierte Licht in ein elektrisches Signal um und führt das elektrische Signal zu seiner Auswertung einer mit der Erfassungseinrichtung 48 verbundenen Bildverarbeitungseinrichtung 24 zu.

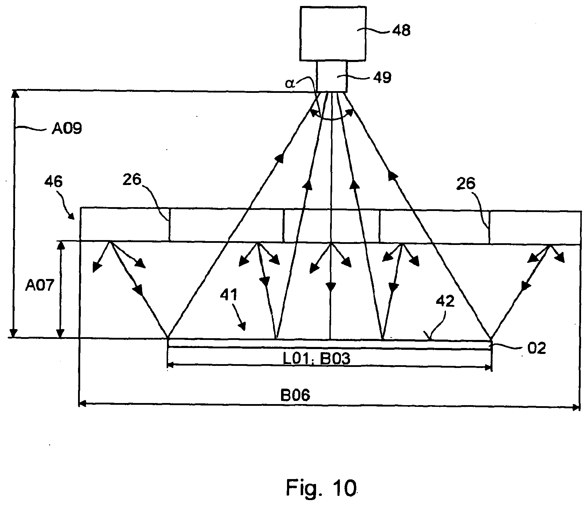

Fig. 10 zeigt eine Ansicht des optischen Inspektionssystems in einer lotrecht zur Bewegungsrichtung 44 des Bogens 02 stehenden Ebene. Die Beleuchtungseinrichtung 46 und der auf der Oberfläche 42 des Bogens 02 beleuchtete Beleuchtungsstreifen 41 sind im Abstand A07 parallel zueinander angeordnet, jedoch kann eine Erstreckung der Beleuchtungseinrichtung 46, d. h. ihre Länge B06, größer sein als die Länge L01 des Beleuchtungsstreifens 41 oder als die Breite B03 des Bogens 02. Die Beleuchtungseinrichtung 46 ist in vorzugsweise mehrere Module aufgeteilt, d. h. in diesem Beispiel in fünf zeilenförmig nebeneinander angeordnete, wobei die in jedem Modul angeordneten Lichtquellen 47 jeweils Licht zum Beleuchtungsstreifen 41 emittieren. Das vom Beleuchtungsstreifen 41 remittierte Licht wird von dem im Abstand A09 von der Oberfläche 42 des Bogens 02 angeordneten Detektor 49 der Erfassungseinrichtung 48 innerhalb eines sich längs zur Länge L01 des Beleuchtungsstreifens 41 öffnenden, räumlichen Erfassungswinkels α erfasst, wobei der Erfassungswinkel α in diesem Beispiel derart bemessen ist, das er das vom Beleuchtungsstreifen 41 remittierte Licht über die gesamte Länge L01 des Beleuchtungsstreifens 41 erfasst. Der Erfassungswinkel α bildet an der Oberfläche 42 des Bogens 02 eine Querschnittsfläche aus, sodass der Erfassungswinkel α zumindest einen Teil einer sich über die Breite B01 des Beleuchtungsstreifens 41 erstreckenden Querschnittsfläche des von der Beleuchtungseinrichtung 46 emittierten Lichtestrahlenbündels erfasst. Die vom Erfassungswinkel α erfasste Querschnittsfläche ist vorzugsweise zumindest so groß wie die auf der Oberfläche 42 des Bogens 02 durch die Länge L01 und Breite B01 des Beleuchtungsstreifens 41 aufgespannte Fläche.

Die Qualität eines mit der Erfassungseinrichtung 48 durch Erfassung des vom Beleuchtungsstreifen 41 remittierten Lichtes aufgenommenen Bildes ist maßgeblich davon abhängig, dass die Lichtquellen 47 der Beleuchtungseinrichtung 46 Licht konstanter Lichtstärke emittieren. Denn Schwankungen in der Lichtstärke des von den Lichtquellen 47 emittierten Lichtes führen in der Erfassungseinrichtung 48 bezüglich des der Bildverarbeitungseinrichtung 24 zugeführten Signals zu demselben Ergebnis wie Änderungen in der Beschaffenheit der Oberfläche 42 des angestrahlten Bogens 02, sodass in der Bildverarbeitungseinrichtung 24 die Ursachen einer Signaländerung nicht unterschieden werden können. Unter diesen Umständen lassen sich aus einer in der Bildverarbeitungseinrichtung 24 vorgenommenen Bildauswertung keine verlässlichen Aussagen über die Beschaffenheit der Oberfläche 42 des angestrahlten Bogens 02 gewinnen.

Abhilfe bieten hier Maßnahmen, die die Lichtstärke des von den Lichtquellen 47 der Beleuchtungseinrichtung 46 emittierten Lichtes konstant halten. Die in der Beleuchtungseinrichtung 46 verwendeten Lichtquellen 47 sind vorzugsweise als lichtstarke Leuchtdioden 47 oder Laserdioden 47 ausgebildet, deren Lichtstärke temperaturabhängig ist. Im Folgenden werden zur Erzielung einer konstanten Lichtstärke Maßnahmen zur Temperaturstabilisierung der auf der Platine 21 angeordneten Lichtquellen 47 beschrieben. Der Vorteil dieser Lösung besteht darin, dass die thermische Last der Lichtquellen 47 direkt am Entstehungsort abgeführt wird, wodurch sich kurze Regelzeiten erreichen lassen.

Die Lichtquellen 47 sind vorzugsweise auf einer mit weiteren elektronischen Bauelementen bestückbaren und mit Leiterbahnen versehenen Platine 21 angeordnet. Der Halbleiter der Leuchtdioden 47 oder Laserdioden 47 steht vorzugsweise in direktem Berührungskontakt mit der Platine 21, die z. B. als MCPCB (metal core printed circuit board) oder als eine Platine 21 mit einem Kern aus Aluminium ausgebildet ist und an ihrer die Leuchtdioden 47 oder Laserdioden 47 tragenden Montageseite zur Ausbildung eines möglichst geringen Wärmeübergangswiderstandes nur eine sehr dünne Auflage auf ihrem wärmeleitenden Untergrund aufweist.

Da die Bewegung des bewegten Bogens 02 in einer Druckmaschine oder einer ein Druckerzeugnis weiter verarbeitenden Maschine mit einer Geschwindigkeit von mehreren Metern pro Sekunde erfolgt, z. B. 3 m/s oder mehr, wobei z. B. in einer Bogendruckmaschine 18.000 oder auch mehr Bogen 02 pro Stunde bedruckt und durch die Druckmaschine transportiert werden, ist das optische Inspektionssystem derart auszulegen, dass von dem bewegten Bogen 02 eine brauchbare Bildaufnahme möglich ist. Dabei ist zu beachten, dass sich bei einer als eine Zeilenkamera 48 ausgebildeten Erfassungseinrichtung 48 die erfasste Menge des von der Oberfläche 42 des bewegten Bogens 02 remittierten Lichtes in Abhängigkeit von der Geschwindigkeit des bewegten Bogens 02 ändert. Dadurch ändert sich auch die Helligkeit der Bildaufnahme. Bei größeren Geschwindigkeitsänderungen, wie sie in den genannten Maschinen üblicherweise auftreten, kann die Bildaufnahme unbrauchbar werden.

Statt die Bildaufnahme der Zeilenkamera 48 mit einem Encoder mit der Geschwindigkeit des bewegten Bogens 02 zu synchronisieren, wird vorgeschlagen, eine Einschaltdauer t3 einer einzelnen Lichtquelle 47 oder einer Gruppe von Lichtquellen 47 der Beleuchtungseinrichtung 46, die von einer von der Steuereinrichtung 23 gesteuerten Stromquelle 22, insbesondere einer Konstantstromquelle 22, angesteuert werden, mit einer Triggerung, d. h. einer Belichtungsdauer t1 der Zeilenkamera 48 zu synchronisieren, sodass die Oberfläche 42 des bewegten Bogens 02 unabhängig von der Geschwindigkeit des bewegten Bogens 02 immer mit der gleichen Lichtmenge beleuchtet wird. Dadurch ergibt sich eine konstante Helligkeit für das von der Zeilenkamera 48 aufgenommene Bild über einen weiten Bereich der Geschwindigkeit des bewegten Bogens 02.

Vorzugsweise sind - wie bereits beschrieben - in der Beleuchtungseinrichtung 46 mehrere Gruppen von Lichtquellen 47 vorgesehen, denen jeweils mindestens eine Stromquelle 22, insbesondere eine Konstantstromquelle 22, zugeordnet ist. Die Einschaltzeiten t3 der Lichtquellen 47 werden von der mit der Beleuchtungseinrichtung 46 verbundenen Steuereinrichtung 23 z. B. gruppenweise oder auch einzeln unabhängig voneinander von den jeweiligen Stromquellen 22 angesteuert, sodass sich über die Länge der vorzugsweise zeilenförmig angeordneten Lichtquellen 47 der Beleuchtungseinrichtung 46 ein Lichtmengenprofil einstellen lässt. Die Einstellung eines Lichtmengenprofils vorzugsweise längs zur Länge L01 des Beleuchtungsstreifens 41 hat den Vorteil, dass Transmissionsverluste durch eine nicht dargestellte Optik der Zeilenkamera 48 ausgeglichen werden können.

Darüber hinaus kann vorgesehen sein, dass ein z. B. mit der Steuereinrichtung 23 verbundener Lichtsensor 37 die abgestrahlte Lichtmenge der Lichtquellen 47 der Beleuchtungseinrichtung 46 misst, um anhand des Messsignals des Lichtsensors 37 die Einschaltdauer t3 der von den Stromquellen 22 mit der Steuereinrichtung 23 gesteuerten Lichtquellen 47 z. B. an ein Degradationsverhalten der Lichtquellen 47 anzupassen und mit der Ansteuerung der Lichtquellen 47 z. B. eine mit ihrer Alterung nachlassende Abstrahlung in ihrer Lichtmenge zu kompensieren. Auch kann die Steuereinrichtung 23 die Einschaltdauer t3 der Lichtquellen 47 an unterschiedliche optische Eigenschaften des zu beleuchtenden Bogens 02 automatisch anpassen.

### Bezugszeichenliste

- 01: Druckwerk
- 02: Bedruckstoff, Bogen
- 03: Vorratsstapel
- 04: Applikationseinrichtung, Druckeinrichtung, Druckwerk
- 05: -
- 06: Finishing-Station, Lackwerk
- 07: Auslageverlängerung
- 08: Ablagestapel
- 09: Ablagestapel
- 10: Prüfeinrichtung
- 11: Prüfeinrichtung
- 12: Applikationseinrichtung, Aufklebeinrichtung
- 13: Prüfeinrichtung
- 14 bis 20: -
- 21: Platine
- 22: Stromquelle, Konstantstromquelle
- 23: Steuereinrichtung
- 24: Bildverarbeitungseinrichtung
- 25: -
- 26: Trennfuge
- 27 bis 37: -
- 38: Schutz, Fußtritt
- 39: Druckwerkszylinder, Gegendruckzylinder
- 40: -
- 41: Gebilde, Beleuchtungsstreifen
- 42: Oberfläche
- 43: -
- 44: Bewegungsrichtung
- 45: -
- 46: Beleuchtungseinrichtung
- 47: Lichtquelle, Leuchtdiode, Laserdiode
- 48: Erfassungseinrichtung, Bildaufnahmeeinheit, Kamera, Zeilenkamera, Farbzeilenkamera
- 49: Detektor, CCD-Array, Photodiode

- A07: Abstand
- A09: Abstand

- B01: Breite
- B03: Breite
- B06: Länge
- L01: Länge

- AK: Fläche, Kugeloberfläche

- α: Erfassungswinkel
- γ: Winkel
- ω: Raumwinkel

## Patentansprüche

1. Druckmaschine mit mindestens einem Druckwerk (01) zum Bedrucken eines Bedruckstoffs (02) mit Druckfarbe, mindestens einer Applikationseinrichtung (04; 12) zum Applizieren mindestens eines berührungslosen als RFID-System ausgebildeten Identifikationsmerkmals oder eines Teils hiervon auf den Bedruckstoff (02) sowie mindestens einer Einrichtung zur Inspektion des Druckerzeugnisses, wobei die Druckmaschine mindestens eine erste Prüfeinrichtung (10; 11; 13) zur Prüfung des Identifikationsmerkmals oder eines Teils hiervon aufweist, wobei die erste Prüfeinrichtung (10) in Transportrichtung des Bedruckstoffs (04) gesehen hinter der Applikationseinrichtung (04; 12) und/oder hinter dem mindestens einen Druckwerk (01) oder nach dem letzen Druckwerk (01) der Druckmaschine angeordnet ist, wobei die Druckmaschine mindestens eine zweite Prüfeinrichtung (11) zur Prüfung des Druckbildes des Druckerzeugnisses aufweist, wobei die erste Prüfeinrichtung (10) zur Prüfung von mindestens einer optischen Eigenschaft des Identifikationsmerkmals ausgebildet ist.

2. Druckmaschine nach Anspruch 1, **dadurch gekennzeichnet, dass** mindestens eine Applikationseinrichtung (04) eine Druckeinrichtung (04) zum Aufdrucken eines Identifikationsmerkmals oder eines Teils hiervon ist.

3. Druckmaschine nach Anspruch 2, **dadurch gekennzeichnet, dass** die Druckeinrichtung (04) nach einem Hochdruckverfahren arbeitet.

4. Druckmaschine nach Anspruch 2, **dadurch gekennzeichnet, dass** die Druckeinrichtung (04) nach einem Tiefdruckverfahren arbeitet.

5. Druckmaschine nach Anspruch 2, **dadurch gekennzeichnet, dass** die Druckeinrichtung (04) nach einem Flachdruckverfahren arbeitet.

6. Druckmaschine nach Anspruch 2, **dadurch gekennzeichnet, dass** die Druckeinrichtung (04) ein Offsetdruckwerk ist.

7. Druckmaschine nach Anspruch 1, **dadurch gekennzeichnet, dass** mindestens eine Applikationseinrichtung (04; 12) eine Aufklebeinrichtung (12) zum Aufkleben eines Identifikationsmerkmals oder eines Teils davon ist.

8. Druckmaschine nach Anspruch 1, **dadurch gekennzeichnet, dass** mindestens eine Applikationseinrichtung (04; 12) zum Applizieren eines elektronischen Bauteils wie insbesondere eines Chips auf den Bedruckstoff (02) ausgebildet ist.

9. Druckmaschine nach Anspruch 1, **dadurch gekennzeichnet, dass** das mindestens eine Druckwerk (01) und die mindestens eine Applikationseinrichtung (04; 12) inline geschaltet sind.

10. Druckmaschine nach Anspruch 1, **dadurch gekennzeichnet, dass** die mindestens eine erste Prüfeinrichtung (10; 11; 13) und die mindestens eine Applikationseinrichtung (04; 12) inline geschaltet sind.

11. Druckmaschine nach einem der Ansprüche 1, 9 oder 10 , **dadurch gekennzeichnet, dass** die mindestens eine zweite Prüfeinrichtung (11), das mindestens eine Druckwerk (01) und die mindestens eine erste Prüfeinrichtung (10) inline geschaltet sind.

12. Druckmaschine nach Anspruch 2, **dadurch gekennzeichnet, dass** das mindestens eine Druckwerk (01) in Transportrichtung des Bedruckstoffs (02) gesehen hinter der mindestens einen Druckeinrichtung (04; 12) angeordnet ist.

13. Druckmaschine nach Anspruch 2, **dadurch gekennzeichnet, dass** die erste Prüfeinrichtung (10) an der mindestens einen Druckeinrichtung (04; 12) oder im Anschluss an die mindestens eine Druckeinrichtung (04) angeordnet ist.

14. Druckmaschine nach einem der Ansprüche 1 oder 9 bis 13, **dadurch gekennzeichnet, dass** die zweite Prüfeinrichtung (11) an dem mindestens einen Druckwerk (01) oder im Anschluss an das mindestens eine Druckwerk (01) angeordnet ist.

15. Druckmaschine nach Anspruch 1, **dadurch gekennzeichnet, dass** das mindestens eine Druckwerk (01) ein Offsetdruckwerk ist.

16. Druckmaschine nach Anspruch 15, **dadurch gekennzeichnet, dass** mindestens vier Offsetdruckwerke für den Mehrfarbendruck vorgesehen sind.

17. Druckmaschine nach Anspruch 1, **dadurch gekennzeichnet, dass** der Bedruckstoff (02) als Bogen (02) oder als Bahn ausgeführt ist.

18. Druckmaschine nach Anspruch 1, **dadurch gekennzeichnet, dass** das mindesten eine Druckwerk (01) so ausgebildet ist, dass in axialer Richtung des Druckwerks (01) mehrere Nutzen nebeneinander vorgesehen sind.

19. Druckmaschine nach Anspruch 1, **dadurch gekennzeichnet, dass** das mindestens eine Druckwerk (01) so ausgebildet ist, dass in Längsrichtung mehrere Nutzen hintereinander vorgesehen sind.

20. Druckmaschine nach Anspruch 18 oder 19, **dadurch gekennzeichnet, dass** die Nutzen von Faltschachteln gebildet sind.

21. Druckmaschine nach Anspruch 18 oder 19, **dadurch gekennzeichnet, dass** die Nutzen von Etiketten gebildet sind.

22. Druckmaschine nach Anspruch 1, **dadurch gekennzeichnet, dass** die erste Prüfeinrichtung (10; 11; 13) zur Prüfung von mindestens einer elektrischen bzw. magnetischen bzw. elektromagnetischen Eigenschaft des Identifikationsmerkmals ausgebildet ist.

23. Druckmaschine nach einem der Ansprüche 1 oder 9 bis 22, **dadurch gekennzeichnet, dass** die zweite Prüfeinrichtung (11) zur optischen Prüfung des fertigen Druckerzeugnisses ausgebildet ist.

24. Druckmaschine nach einem der Ansprüche 2 bis 17, **dadurch gekennzeichnet, dass** die Druckeinrichtung (04) zum Aufdrucken mindestens einer Antenne eines RFID-Systems ausgebildet ist.

25. Druckmaschine nach einem der Ansprüche 1 oder 7 bis 24, **dadurch gekennzeichnet, dass** die Aufklebeinrichtung (12) zum Aufkleben mindestens eines Chips eines RFID-Systems ausgebildet ist.

26. Druckmaschine nach Anspruch 1 oder 23, **dadurch gekennzeichnet, dass** zur optischen Prüfung eine CCD-Einrichtung (48, 49) oder CMOS-Einrichtung vorgesehen ist.

27. Druckmaschine nach Anspruch 26, **dadurch gekennzeichnet, dass** die CCD-Einrichtung (48, 49) eine CCD-Zeilenkamera ist.

28. Druckmaschine nach Anspruch 27, **dadurch gekennzeichnet, dass** mittels der CCD-Zeilenkamera (48) die maximale Breite des Bedruckstoffs (02) scannbar ist.

29. Druckmaschine nach einem der Ansprüche 1 oder 9 bis 28, **dadurch gekennzeichnet, dass** die zweite Prüfeinrichtung (11) zur Kontrolle des Registers und/oder der Farbeigenschaften des Druckbildes ausgebildet ist.

30. Druckmaschine nach einem der Ansprüche 1 oder 9 bis 29, **dadurch gekennzeichnet, dass** die zweite Prüfeinrichtung (11) in Transportrichtung des Bedruckstoffs (02) gesehen hinter dem mindestens einen Druckwerk (01) bzw. oder nach dem letzen Druckwerk (01) der Druckmaschine angeordnet ist.

31. Druckmaschine nach Anspruch 1, **dadurch gekennzeichnet, dass** die erste Prüfeinrichtung (10) in Transportrichtung des Bedruckstoffes (02) gesehen hinter der Applikationseinrichtung (04; 12) und vor dem ersten Druckwerk (01) angeordnet ist.

32. Druckmaschine nach Anspruch 17, **dadurch gekennzeichnet, dass** die bedruckten Bogen (02) einer Sortiereinrichtung zuführbar sind.

33. Druckmaschine nach Anspruch 32, **dadurch gekennzeichnet, dass** am Transportweg der Bogen (02) zwei hintereinander angeordnete Ablagestapel (08, 09) vorgesehen sind, denen die bedruckten Bogen (02) je nach Qualität wahlweise zuführbar sind.

34. Verfahren zur Herstellung eines Druckerzeugnisses in einer Druckmaschine, wobei auf einen Bedruckstoff (02) ein berührungsloses als RFID-Systen ausgebildetes Identifikationsmerkmal oder ein Teil hiervon appliziert wird, wobei der Bedruckstoff (02) mit Druckfarbe bedruckt wird, wobei anschließend eine optische Prüfung zumindest eines Teiles des auf dem Bedruckstoff (02) befindlichen Druckbildes vorgenommen wird, wobei vor oder nach dem Bedrucken eine Eigenschaft oder ein Merkmal des Identifikationsmerkmals überprüft wird, wobei das Identifikationsmerkmal nach seiner Applikation hinsichtlich einer elektrischen, magnetischen oder elektromagnetischen Eigenschaft mittels einer berührungslos arbeitenden Prüfeinrichtung (10; 11; 13) überprüft wird.

35. Verfahren nach Anspruch 34, **dadurch gekennzeichnet, dass** das berührungslose Identifikationsmerkmal oder ein Teil hiervon mittels einer Drucktechnik appliziert wird.

36. Verfahren nach Anspruch 34 oder 35, **dadurch gekennzeichnet, dass** das Identifikationsmerkmal nach seiner Applikation hinsichtlich einer elektrischen, magnetischen oder elektromagnetischen Eigenschaft mittels einer induktiv arbeitenden Prüfeinrichtung (10; 11; 13) überprüft wird.

37. Verfahren nach einem der Ansprüche 34 bis 36, **dadurch gekennzeichnet, dass** das Identifikationsmerkmal nach seiner Applikation hinsichtlich einer optischen Eigenschaft überprüft wird.

38. Verfahren nach Anspruch 34, **dadurch gekennzeichnet, dass** nach Aufbringen des Druckbildes die optischen Eigenschaften des gesamten Druckerzeugnisses überprüft werden.

39. Verfahren nach einem der Ansprüche 34 bis 38, **dadurch gekennzeichnet, dass** zunächst das Identifikationsmerkmal nach seiner Applikation hinsichtlich einer optischen Eigenschaft überprüft wird und dass anschließend nach Aufbringen des Druckbildes die optischen Eigenschaften des gesamten Druckerzeugnisses überprüft werden.

40. Verfahren nach Anspruch 39, **dadurch gekennzeichnet, dass** die optische Prüfung zumindest eines Teiles des auf dem Bedruckstoff (02) aufgedruckten Bildes mittels einer weiteren Prüfeinrichtung (12) vorgenommen wird.

41. Verfahren nach Anspruch 34, **dadurch gekennzeichnet, dass** die elektrische, magnetische oder elektromagnetische Prüfung des Identifikationsmerkmals bezogen auf die Transportrichtung an einer ersten Stelle und die optische Prüfung zumindest eines Teiles des Druckbildes an einer anderen Stelle vorgenommen wird.

42. Verfahren nach Anspruch 34, **dadurch gekennzeichnet, dass** das Identifikationsmerkmal mehrfarbig überdruckt wird.

43. Verfahren nach Anspruch 34, **dadurch gekennzeichnet, dass** inline Eigenschaften des RFID-Systems geprüft werden wie insbesondere Frequenz des Antennenschwingkreises und/oder die Identifikationsnummer und/oder der Schlüssel einer digitalen Signatur.

44. Verfahren nach Anspruch 34, **dadurch gekennzeichnet, dass** das Identifikationsmerkmal und das Druckbild auf der gleichen Seite des Bedruckstoffes (02) aufgebracht werden.

45. Verfahren nach Anspruch 34, **dadurch gekennzeichnet, dass** zuerst das Identifikationsmerkmal und anschließend das Druckbild auf dem Bedruckstoff (02) in einer Druckmaschine aufgebraucht werden.

46. Verfahren nach einem der Ansprüche 34 bis 44, **dadurch gekennzeichnet, dass** das Verfahren in einer Druckmaschine nach einem der Ansprüche 1 bis 33 durchgeführt wird.

47. Druckmaschine nach Anspruch 1, **dadurch gekennzeichnet, dass** die optische Eigenschaft des Identifikationsmerkmals die Form von elektrischen Leiterbahnen, die eine Antenne eines RFID-Systems bilden, ist.

48. Druckmaschine nach Anspruch 2, **dadurch gekennzeichnet, dass** die Druckeinrichtung (04) elektrisch leitfähiges Material druckend angeordnet ist.

49. Druckmaschine nach Anspruch 2, **dadurch gekennzeichnet, dass** die Druckeinrichtung (04) elektrisch isolierendes Material druckend angeordnet ist.

50. Druckmaschine nach Anspruch 2, **dadurch gekennzeichnet, dass** die Druckeinrichtung (04) elektrisch halbleitendes Material druckend angeordnet ist.

51. Druckmaschine nach Anspruch 48, 49 oder 50, **dadurch gekennzeichnet, dass** das Material ein Polymer aufweist.

52. Druckmaschine nach Anspruch 49 oder 50, **dadurch gekennzeichnet, dass** mindestens zwei Druckeinrichtungen (04) angeordnet sind.

53. Druckmaschine nach Anspruch 48, 49 oder 50, **dadurch gekennzeichnet, dass** mindestens drei Druckeinrichtungen (04) angeordnet sind.

## Claims

1. A printing press with at least one printing couple (01) for printing a material to be printed (02) with printing ink, at least one application device (04; 12) for applying at least one contact-less identification feature designed in the form of an RFID system or a part thereof onto the material to be printed (02) and at least one device for the inspection of the printed product, wherein the printing press has at least one first checking device (10; 11; 13) for checking the identification feature or a part thereof, wherein the first checking device (10) is arranged behind the application device (04; 12) and/or behind the at least one printing couple (01) or downstream of the last printing couple (01) of the printing press as viewed in the conveying direction of the material to be printed (04), wherein the printing press has at least one second checking device (11) for checking the print image of the printed product, wherein the first checking device (10) is designed in order to check at least one optical property of the identification feature.

2. A printing press according to claim 1, **characterised in that** at least one application device (04) is a printing device (04) for printing an identification feature or a part thereof.

3. A printing press according to claim 2, **characterised in that** the printing device (04) operates in accordance with a letterpress printing method.

4. A printing press according to claim 2, **characterised in that** the printing device (04) operates in accordance with a rotogravure printing method.

5. A printing press according to claim 2, **characterised in that** the printing device (04) operates in accordance with a flatbed printing method.

6. A printing press according to claim 2, **characterised in that** the printing device (04) is an offset printing couple.

7. A printing press according to claim 1, **characterised in that** at least one application device (04; 12) is a sticking device (12) for sticking on an identification feature or a part thereof.

8. A printing press according to claim 1, **characterised in that** at least one application device (04; 12) is designed in order to apply an electronic component, such as in particular a chip, to the material to be printed (02).

9. A printing press according to claim 1, **characterised in that** the at least one printing couple (01) and the at least one application device (04; 12) are connected in-line.

10. A printing press according to claim 1, **characterised in that** the at least one first checking device (10; 11; 13) and the at least one application device (04; 12) are connected in-line.

11. A printing press according to any one of claims 1, 9 or 10, **characterised in that** the at least one second checking device (11), the at least one printing couple (01) and the at least one first checking device (10) are connected in-line.

12. A printing press according to claim 2, **characterised in that** the at least one printing couple (01) is arranged behind the at least one printing device (04; 12) as viewed in the conveying direction of the material to be printed (02).

13. A printing press according to claim 2, **characterised in that** the first checking device (10) is arranged on the at least one printing device (04; 12) or adjoining the at least one printing device (04).

14. A printing press according to any one of claims 1 or 9 to 13, **characterised in that** the second checking device (11) is arranged on the at least one printing couple (01) or adjoining the at least one printing couple (01).

15. A printing press according to claim 1, **characterised in that** the at least one printing couple (01) is an offset printing couple.

16. A printing press according to claim 15, **characterised in that** at least four offset printing couples are provided for multiple-colour printing.

17. A printing press according to claim 1, **characterised in that** the material to be printed (02) is in the form of a sheet (02) or in the form of a web.

18. A printing press according to claim 1, **characterised in that** the at least one printing couple (01) is designed in such a way that a multiplicity of copies from one sheet are provided adjacent to one another in the axial direction of the printing couple (01).

19. A printing press according to claim 1, **characterised in that** the at least one printing couple (01) is designed in such a way that a multiplicity of copies from one sheet are provided one behind the other in the longitudinal direction.

20. A printing press according to claim 18 or 19, **characterised in that** the copies from one sheet are formed by folding boxes.

21. A printing press according to claim 18 or 19, **characterised in that** the copies from one sheet are formed by labels.

22. A printing press according to claim 1, **characterised in that** the first checking device (10; 11; 13) is designed in order to check at least one electrical or magnetic or electromagnetic property of the identification feature.

23. A printing press according to any one of claims 1 or 9 to 22, **characterised in that** the second checking device (11) is designed for the optical checking of the finished printed product.

24. A printing press according to any one of claims 2 to 17, **characterised in that** the printing device (04) is designed in order to print at least one aerial of an RFID system.

25. A printing press according to any one of claims 1 or 7 to 24, **characterised in that** the sticking device (12) is designed in order to stick on at least one chip of an RFID system.

26. A printing press according to claim 1 or 23, **characterised in that** a CCD device (48, 49) or CMOS device is provided for the optical checking.

27. A printing press according to claim 26, **characterised in that** the CCD device (48, 49) is a CCD line camera.

28. A printing press according to claim 27, **characterised in that** the maximum width of the material to be printed (02) is capable of being scanned by means of the CCD line camera (48).

29. A printing press according to any one of claims 1 or 9 to 28, **characterised in that** the second checking device (11) is designed in order to monitor the register and/or the colour properties of the print image.

30. A printing press according to any one of claims 1 or 9 to 29, **characterised in that** the second checking device (11) is arranged behind the at least one printing couple (01) or downstream of the last printing couple (01) of the printing press respectively as viewed in the conveying direction of the material to be printed (02).

31. A printing press according to claim 1, **characterised in that** the first checking device (10) is arranged behind the application device (04; 12) and upstream of the first printing couple (01) as viewed in the conveying direction of the material to be printed (02).

32. A printing press according to claim 17, **characterised in that** the printed sheets (02) are capable of being supplied to a sorting device.

33. A printing press according to claim 32, **characterised in that** two delivery stacks (08, 09), which are arranged one behind the other and to which the printed sheets (02) are capable of being supplied in a selective manner in accordance with quality, are provided on the conveying path of the sheets (02).

34. A method of producing a printed product in a printing press, wherein a contact-less identification feature designed in the form of an RFID system or a part thereof is applied to a material to be printed (02), wherein the material to be printed (02) is printed with printing ink, wherein an optical checking of at least part of the print image present on the material to be printed (02) is then carried out, wherein a characteristic or a feature of the identification feature is checked before or after the printing, wherein after its application the identification feature is checked with respect to an electrical, magnetic or electromagnetic property by means of a checking device (10; 11; 13) operating without contact.

35. A method according to claim 34, **characterised in that** the contact-less identification feature or a part thereof is applied by means of a printing technique.

36. A method according to claim 34 or 35, **characterised in that** after its application the identification feature is checked with respect to an electrical, magnetic or electromagnetic property by means of a checking device (10; 11; 13) operating inductively.

37. A method according to any one of claims 34 to 36, **characterised in that** after its application the identification feature is checked with respect to an optical property.

38. A method according to claim 34, **characterised in that** after the application of the print image the optical properties of the entire printed product are checked.

39. A method according to any one of claims 34 to 38, **characterised in that** first of all, after its application, the identification feature is checked with respect to an optical property, and after that, after the application of the print image, the optical properties of the entire printed product are checked.

40. A method according to claim 39, **characterised in that** the optical checking of at least part of the image printed onto the material to be printed (02) is carried out by means of a further checking device (12).

41. A method according to claim 34, **characterised in that** the electrical, magnetic or electromagnetic checking of the identification feature with respect to the conveying direction is carried out at a first location and the optical checking of at least part of the print image is carried out at another location.

42. A method according to claim 34, **characterised in that** the identification feature is over-printed in multiple colours.

43. A method according to claim 34, **characterised in that** in-line properties of the RFID system are checked, such as in particular the frequency of the oscillating circuit of the aerial and/or the identification number and/or the key of a digital signature.

44. A method according to claim 34, **characterised in that** the identification feature and the print image are applied to the same side of the material to be printed (02).

45. A method according to claim 34, **characterised in that** first the identification feature and after that the print image are applied in a printing press to the material to be printed (02).

46. A method according to any one of claims 34 to 44, **characterised in that** the method is carried out in a printing press according to any one of claims 1 to 33.

47. A printing press according to claim 1, **characterised in that** the optical property of the identification feature is in the form of electrical conductor tracks which form an aerial of an RFID system.

48. A printing press according to claim 2, **characterised in that** the printing device (04) is arranged so as to print electrically conductive material.

49. A printing press according to claim 2, **characterised in that** the printing device (04) is arranged so as to print electrically insulating material.

50. A printing press according to claim 2, **characterised in that** the printing device (04) is arranged so as to print electrically semi-conducting material.

51. A printing press according to claim 48, 49 or 50, **characterised in that** the material comprises a polymer.

52. A printing press according to claim 49 or 50, **characterised in that** at least two printing devices (04) are provided.

53. A printing press according to claim 48, 49 or 50, **characterised in that** at least three printing devices (04) are provided.

## Revendications

1. Machine à imprimer, comprenant au moins un groupe d'impression (01), pour imprimer un matériau à imprimer (02) avec de l'encre d'impression, au moins un dispositif d'application (04 ; 12), pour appliquer sur le matériau à imprimer (02) au moins une caractéristique d'identification, ou une partie de celle-ci, opérant sans contact sous forme de système RFID, ainsi qu'au moins un dispositif pour l'inspection du produit imprimé, dans laquelle la machine à imprimer présente au moins un premier dispositif de contrôle (10 ; 11 ; 13), pour le contrôle de la caractéristique d'identification, ou d'une partie de celle-ci, dans laquelle le premier dispositif de contrôle (10), observé dans la direction de transport du matériau à imprimer (04), est disposé derrière le dispositif d'application (04 ; 12) et/ou derrière le au moins un groupe d'impression (01), ou après le dernier groupe d'impression (01) de la machine à imprimer, dans laquelle la machine à imprimer présente au moins un deuxième dispositif de contrôle (11), pour le contrôle de l'image d'impression du produit imprimé, dans laquelle le premier dispositif de contrôle (10) est réalisé pour le contrôle d'au moins une propriété optique de la caractéristique d'identification.

2. Machine à imprimer selon la revendication 1, **caractérisée en ce qu'**au moins un dispositif d'application (04) est un dispositif d'impression (04) pour imprimer une caractéristique d'identification ou une partie de celle-ci.

3. Machine à imprimer selon la revendication 2, **caractérisée en ce que** le dispositif d'impression (04) travaille selon un principe d'impression typographique.

4. Machine à imprimer selon la revendication 2, **caractérisée en ce que** le dispositif d'impression (04) travaille selon un principe d'impression en héliogravure.

5. Machine à imprimer selon la revendication 2, **caractérisée en ce que** le dispositif d'impression (04) travaille selon un principe d'impression à plat.

6. Machine à imprimer selon la revendication 2, **caractérisée en ce que** le dispositif d'impression (04) est un groupe d'impression offset.

7. Machine à imprimer selon la revendication 1, **caractérisée en ce qu'**au moins un dispositif d'application (04 ; 12) est un dispositif de collage (12), pour coller une caractéristique d'application, ou une partie de celle-ci.

8. Machine à imprimer selon la revendication 1, **caractérisée en ce qu'**au moins un dispositif d'application (04 ; 12) est réalisé pour appliquer un composant électronique, tel qu'en particulier une puce, sur le matériau à imprimer (02).

9. Machine à imprimer selon la revendication 1, **caractérisée en ce que** le au moins un groupe d'impression (01) et le au moins un dispositif d'application (04 ; 12) sont branchés en ligne.

10. Machine à imprimer selon la revendication 1, **caractérisée en ce que** le au moins un premier dispositif de contrôle (10; 11 ; 13) et le au moins un dispositif d'application (04 ; 12) sont branchés en ligne.

11. Machine à imprimer selon l'une des revendications 1, 9 ou 10, **caractérisée en ce que** le au moins un deuxième dispositif de contrôle (11), le au moins un groupe d'impression (01) et le au moins un premier dispositif de contrôle (10) sont branchés en ligne.

12. Machine à imprimer selon la revendication 2, **caractérisée en ce que** le au moins un groupe d'impression (01), en observant dans la direction de transport du matériau à imprimer (02), est disposé derrière le au moins un dispositif d'impression (04 ; 12).

13. Machine à imprimer selon la revendication 2, **caractérisée en ce que** le premier dispositif de contrôle (10) est disposé sur le au moins un dispositif d'impression (04 ; 12) ou en raccordement au au moins un dispositif d'impression (04).

14. Machine à imprimer selon l'une des revendication 1 ou 9 à 13, **caractérisée en ce que** le deuxième dispositif de contrôle (11) est disposé sur le au moins un groupe d'impression (01) ou en raccordement au au moins un groupe d'impression (01).

15. Machine à imprimer selon la revendication 1, **caractérisée en ce que** le au moins un groupe d'impression (01) est un groupe d'impression offset.

16. Machine à imprimer selon la revendication 15, **caractérisée en ce qu'**au moins quatre groupes d'impression offset sont prévus, pour l'impression en plusieurs couleurs.

17. Machine à imprimer selon la revendication 1, **caractérisée en ce que** le matériau à imprimer (02) est réalisé sous forme de feuille (02) ou de bande.

18. Machine à imprimer selon la revendication 1, **caractérisée en ce que** le au moins un groupe d'impression (01) est réalisé de manière que plusieurs parties utiles ou flans soient prévu(e)s, les unes à côté des autres dans la direction axiale du groupe d'impression.

19. Machine à imprimer selon la revendication 1, **caractérisée en ce que** le au moins un groupe d'impression (01) est réalisé de manière que plusieurs parties utiles ou flans soient prévu(e)s, les unes derrière les autres dans la direction longitudinale.

20. Machine à imprimer selon la revendication 18 ou 19, **caractérisée en ce que** les flans sont formés de boîtes pliantes.

21. Machine à imprimer selon la revendication 18 ou 19, **caractérisée en ce que** les flans sont formés d'étiquettes.

22. Machine à imprimer selon la revendication 1, **caractérisée en ce que** le premier dispositif de contrôle (10 ; 11 ; 13) est réalisé pour le contrôle d'au moins une propriété électrique, ou magnétique ou électromagnétique de la caractéristique d'identification.

23. Machine à imprimer selon l'une des revendications 1 ou 9 à 22, **caractérisée en ce que** le deuxième dispositif de contrôle (11) est réalisé pour le contrôle optique du produit imprimé achevé.

24. Machine à imprimer selon l'une des revendications 2 à 17, **caractérisée en ce que** le dispositif d'impression (04) est réalisé pour l'impression d'au moins une antenne d'un système RFID.

25. Machine à imprimer selon l'une des revendications 1 ou 7 à 24, **caractérisée en ce que** le dispositif de collage (12) est réalisé pour coller au moins une puce électronique d'un système RFID.

26. Machine à imprimer selon la revendication 1 ou 23, **caractérisée en ce qu'**un dispositif CCD (48, 49) ou un dispositif CMOS est prévu pour effectuer le contrôle optique.

27. Machine à imprimer selon la revendication 26, **caractérisée en ce que** le dispositif CCD (48, 49) est une caméra à ligne à éléments CCD.

28. Machine à imprimer selon la revendication 27, **caractérisée en ce que** la largeur maximale du matériau à imprimer (02) peut être appréhendée par balayage au moyen de la caméra à ligne à éléments CCD (48).

29. Machine à imprimer selon l'une des revendications 1 ou 9 à 28, **caractérisée en ce que** le deuxième dispositif de contrôle (11) est réalisé pour le contrôle du repérage et/ou des propriétés de couleur de l'image d'impression.

30. Machine à imprimer selon l'une des revendications 1 ou 9 à 29, **caractérisée en ce que** le deuxième dispositif de contrôle (11) est disposé, en observant dans la direction de transport du matériau à imprimer (02), derrière le au moins un groupe d'impression (01) ou après le dernier groupe d'impression (01) de la machine à imprimer.

31. Machine à imprimer selon la revendication 1, **caractérisée en ce que** le premier dispositif de contrôle (10) est disposé, en observant dans la direction de transport du matériau à imprimer (02), derrière le dispositif d'application (04 ; 12) et avant le premier groupe d'impression (01).

32. Machine à imprimer selon la revendication 17, **caractérisée en ce que** les feuilles (02) imprimées sont susceptibles d'être amenées à un dispositif de tri.

33. Machine à imprimer selon la revendication 32, **caractérisée en ce que**, sur le chemin de transport des feuilles (02), sont prévues deux piles de dépose (08, 09) disposées l'une derrière l'autre, auxquelles les feuilles (02) imprimées sont susceptibles d'être amenées au choix, selon la qualité.

34. Procédé de fabrication d'un produit imprimé dans une machine à imprimer, dans lequel, sur un matériau à imprimer (02), est appliqué une caractéristique d'identification, ou une partie de celle-ci, opérant sans contact sous la forme de système RFID, dans lequel le matériau à imprimer (02) est imprimé avec une encre d'impression, dans lequel un contrôle optique d'au moins une partie de l'image d'impression se trouvant sur le matériau à imprimer (02) est ensuite effectué, dans lequel une propriété ou une caractéristique de la caractéristique d'identification est vérifiée avant ou après impression, dans lequel la caractéristique d'identification est vérifiée après son application, eu égard à une propriété électrique, magnétique ou électromagnétique, au moyen d'un dispositif de contrôle (10 ; 11 ; 13) travaillant sans contact.

35. Procédé selon la revendication 34, **caractérisé en ce que** la caractéristique d'identification opérant sans contact, ou une partie de celle-ci, est appliquée au moyen d'une technique d'impression.

36. Procédé selon la revendication 34 ou 35, **caractérisé en ce que** la caractéristique d'identification est vérifiée après son application, eu égard à une propriété électrique, magnétique ou électromagnétique, au moyen d'un dispositif de contrôle (10 ; 11 ; 13) travaillant de façon inductive.

37. Procédé selon l'une des revendications 34 à 36, **caractérisé en ce que** la caractéristique d'identification est vérifiée après son application, eu égard à une propriété optique.

38. Procédé selon la revendication 34, **caractérisé en ce que** les propriétés optiques de l'ensemble du produit imprimé sont vérifiées après application de l'image d'impression.

39. Procédé selon l'une des revendication 34 à 38, **caractérisé en ce que**, d'abord, la caractéristique d'identification est vérifiée après son application, eu égard à une propriété optique et, ensuite, les propriétés optiques de l'ensemble du produit imprimé sont vérifiées après application de l'image d'impression.

40. Procédé selon la revendication 39, **caractérisé en ce que** le contrôle optique, d'au moins une partie de l'image imprimée sur le matériau à imprimer (02), est effectué au moyen d'un autre dispositif de contrôle (12).

41. Procédé selon la revendication 34, **caractérisé en ce que** le contrôle électrique, magnétique ou électromagnétique de la caractéristique d'identification est effectué en un premier emplacement, en se référant à la direction de transport, et le contrôle optique d'au moins d'une partie de l'image d'impression est effectué en un autre emplacement.

42. Procédé selon la revendication 34, **caractérisé en ce que** la caractéristique d'identification est surimprimée en plusieurs couleurs.

43. Procédé selon la revendication 34, **caractérisé en ce que** des propriétés en ligne du système RFID sont vérifiées, telles que, en particulier, la fréquence du circuit oscillant d'antenne et/ou le numéro d'identification et/ou la clé d'une signature numérique.

44. Procédé selon la revendication 34, **caractérisé en ce que** la caractéristique d'identification et l'image d'impression sont appliquées sur la même face du matériau à imprimer (02).

45. Procédé selon la revendication 34, **caractérisé en ce que**, d'abord, la caractéristique d'identification et, ensuite, l'image d'impression sont appliquées sur le matériau à imprimer (02), dans une machine à imprimer.

46. Procédé selon l'une des revendications 34 à 44, **caractérisé en ce que** le procédé est mis en oeuvre dans une machine à imprimer selon l'une des revendications 1 à 33.

47. Machine à imprimer selon la revendication 1, **caractérisée en ce que** la propriété optique de la caractéristique d'identification est la forme de pistes conductrices électriques, formant une antenne d'un système RFID.

48. Machine à imprimer selon la revendication 2, **caractérisée en ce que** le dispositif d'impression (04) est disposé en imprimant un matériau conducteur de l'électricité.

49. Machine à imprimer selon la revendication 2, **caractérisée en ce que** le dispositif d'impression (04) est disposé en imprimant un matériau isolant de l'électricité.

50. Machine à imprimer selon la revendication 2, **caractérisée en ce que** le dispositif d'impression (04) est disposé en imprimant un matériau semi-conducteur de l'électricité.

51. Machine à imprimer selon la revendication 48, 49 ou 50, **caractérisée en ce que** le matériau présente un polymère.

52. Machine à imprimer selon la revendication 49 ou 50, **caractérisée en ce qu'**au moins deux dispositifs d'impression (04) sont disposés.

53. Machine à imprimer selon la revendication 48, 49 ou 50, **caractérisée en ce qu'**au moins trois dispositifs d'impression (04) sont disposés.
